# EUROPEAN PATENT APPLICATION

(11) **EP 4 456 677 A1**
(43) Date of publication of application: **30.10.2024**
(21) Application number: 22911649.6
(22) Date of filing: 23.11.2022
(51) Int. Cl.: H05K 1/02, H05K 1/11, H05K 3/28, H01L 23/538, H01L 23/00, G06K 19/073

(54) **SMART IC SUBSTRATE, SMART IC MODULE, AND IC CARD COMPRISING SAME**

(30) Priority: 22.12.2021 KR 20210185364
(71) Applicant: LG INNOTEK CO., LTD., Seoul 07796 (KR)
(72) Inventor: KIM, Seung Joon, Seoul 07796 (KR); LEE, Do Yun, Seoul 07796 (KR); JEONG, Dae Hwi, Seoul 07796 (KR)
(74) Representative: DREISS Patentanwälte PartG mbB
(86) International application number: PCT/KR2022/018567
(87) International publication number: WO 2023/121013

(57) **Abstract**

A smart IC substrate according to an embodiment includes a substrate including a first surface and a second surface opposite to the first surface; a first circuit pattern disposed on the first surface; and a space region between the first circuit pattern, wherein the substrate includes a plurality of via holes passing through the first surface and the second surface, wherein the substrate has a first region and a second region other than the first region, wherein the first circuit pattern includes a first circuit pattern part and a second circuit pattern part having different thicknesses, wherein a thickness of the first circuit pattern part is greater than a thickness of the second circuit pattern part, wherein the first circuit pattern part is disposed in the first region and the second region, wherein the second circuit pattern part is disposed only in the first region, and wherein the second circuit pattern part is disposed in at least one of a position that overlaps the via hole and a position that does not overlap the via hole in a thickness direction of the substrate.

## Description

### [Technical Field]

An embodiment re An embodiment relates to a smart IC substrate, a smart IC module, and an IC card comprising the same.

### [Background Art]

An IC card may be formed by combining a smart IC module and a card module.

The smart IC module is a substrate on which an IC that stores personal security information required for electronic residence cards, credit card USIMs, etc. is mounted. The smart IC can transmit the information to a reader in a form of an electrical signal.

The smart IC module may be classified into a single type and a dual type according to a structure of the substrate. In addition, the smart IC module may be classified into contact, contactless, hybrid, and combi cards according to a form of a card used.

In detail, the contact smart IC module uses a method of transmitting and receiving information by physical contact. In addition, the contactless smart IC module uses a method of transmitting and receiving information without physical contact using an NFC (traffic card, etc.) function. In addition, the combi smart IC module and the hybrid smart IC module use a method that includes both the physical contact function and the NFC function without physical contact.

The smart IC module may display identification patterns such as texts, symbols, and numbers to identify the IC card. For example, a circuit pattern can be used to display identification patterns such as texts, symbols, and numbers on a smart IC module. As a result, an issuing organization, purpose, etc. of the IC card can be identified from outside the IC card.

Meanwhile, a plurality of via holes may be formed in the smart IC module to connect circuit patterns of a contact side and a bonding side.

Accordingly, a space and location in which the identification pattern is formed may be limited by the via hole. Additionally, when forming an identification pattern such as a separate dummy pattern, there is a problem in that the size of the smart IC module increases.

Therefore, there are required a smart IC substrate, a smart IC module, and an IC card including the same having a new structure capable of solving the above problems.

### [Disclosure]

### [Technical Problem]

The embodiment provides a smart IC substrate, a smart IC module, and an IC card including the same that can easily form identification patterns such as various texts, symbols, and numbers. Additionally, the embodiment provides a smart IC substrate, a smart IC module, and an IC card including the same that can improve the degree of freedom in exterior design.

### [Technical Solution]

A smart IC substrate according to an embodiment includes a substrate including a first surface and a second surface opposite to the first surface; a first circuit pattern disposed on the first surface; and a space region between the first circuit pattern, wherein the substrate includes a plurality of via holes passing through the first surface and the second surface, wherein the substrate has a first region and a second region other than the first region, wherein the first circuit pattern includes a first circuit pattern part and a second circuit pattern part having different thicknesses, wherein a thickness of the first circuit pattern part is greater than a thickness of the second circuit pattern part, wherein the first circuit pattern part is disposed in the first region and the second region, wherein the second circuit pattern part is disposed only in the first region, and wherein the second circuit pattern part is disposed in at least one of a position that overlaps the via hole and a position that does not overlap the via hole in a thickness direction of the substrate.

A smart IC substrate according to an embodiment includes a substrate including a first surface and a second surface opposite to the first surface; a first circuit pattern disposed on the first surface; and a space region between the first circuit pattern, wherein the substrate includes a plurality of via holes passing through the first surface and the second surface, wherein the substrate has a first region and a second region other than the first region, wherein the first circuit pattern includes a first circuit pattern part, a second-first circuit pattern part, and a second-second circuit pattern part having different thicknesses, wherein a thickness of the first circuit pattern part and a thickness of the second-second circuit pattern part are greater than a thickness of the second-first circuit pattern part, wherein the first circuit pattern part is disposed in the second region, wherein the second-first circuit pattern part and the second-second circuit pattern part are disposed only in the first region, and wherein the second-first circuit pattern part is disposed in at least one of a position that overlaps the via hole and a position that does not overlap the via hole in a thickness direction of the substrate.

### [Advantageous Effects]

The smart IC substrate, smart IC module, and IC card according to the embodiment include an identification pattern.

In detail, the circuit pattern is etched to form an identification pattern having an engraved or embossed shape.

Accordingly, the user can easily identify the information of the IC card from the outside through the identification pattern.

Additionally, the identification pattern may be formed by partially etching the circuit pattern. Accordingly, the identification pattern can be formed at various positions regardless of a position of the via hole.

Additionally, the identification pattern may be recognized in a different color from other circuit patterns. Accordingly, the user can easily identify the identification pattern from the outside.

Additionally, the identification pattern may have a different color from other circuit patterns. Accordingly, the user can easily identify the identification pattern from the outside.

Additionally, a reinforcing part made of resin or metal may be disposed on the identification pattern. Accordingly, corrosion of the circuit pattern can be prevented. Additionally, the degree of freedom in exterior design can be improved by applying various colors to the reinforcing part.

### [Description of Drawings]

FIG. 1 is a top view of an IC card according to an embodiment.
FIG. 2 is a top view of a first surface of a smart IC substrate according to an embodiment.
FIG. 3 is a top view of the first surface of a smart IC substrate according to another embodiment.
FIGS. 4 and 5 are top views of a second surface of a smart IC substrate according to an embodiment.
FIGS. 6 and 7 are top views of a bonding side of a smart IC module in which a chip is disposed on a second surface of a smart IC substrate.
FIG. 8 is a cross-sectional view taken along a A-A' region of FIGS. 2 and 6.
FIG. 9 is a cross-sectional view taken along a A-A' region of FIGS. 2 and 7.
FIG. 10 is a cross-sectional view taken along a B-B' region of FIGS. 3 and 6.
FIG. 11 is a cross-sectional view taken along a B-B' region of FIGS. 3 and 7.
FIG. 12 is a cross-sectional view of another embodiment taken along a B-B' region of FIGS. 3 and 6.
FIG. 13 is a cross-sectional view of another embodiment taken along a B-B' region of FIGS. 3 and 7.
FIG. 14 is a cross-sectional view of another embodiment taken along a A-A' region of FIGS. 2 and 6.
FIG. 15 is a cross-sectional view of another embodiment taken along a A-A' region of FIGS. 2 and 7.
FIG. 16 is a cross-sectional view of another embodiment taken along a A-A' region of FIGS. 2 and 6.
FIG. 17 is a cross-sectional view of another embodiment taken along a A-A' region of FIGS. 2 and 7.
FIG. 18 is a cross-sectional view of another embodiment taken along a B-B' region of FIGS. 3 and 6.
FIG. 19 is a cross-sectional view of another embodiment taken along a B-B' region of FIGS. 3 and 7.
FIG. 20 is a cross-sectional view of another embodiment taken along a B-B' region of FIGS. 3 and 6.
FIG. 21 is a cross-sectional view of another embodiment taken along a B-B' region of FIGS. 3 and 7.
FIG. 22 is a cross-sectional view of another embodiment taken along a A-A' region of FIGS. 2 and 6.
FIG. 23 is a cross-sectional view of another embodiment taken along a A-A' region of FIGS. 2 and 7.
FIG. 24 is a cross-sectional view of another embodiment taken along a B-B' region of FIGS. 3 and 6.
FIG. 25 is a cross-sectional view of another embodiment taken along a B-B' region of FIGS. 3 and 7.
FIG. 26 is a cross-sectional view of another embodiment taken along a A-A' region of FIG. 2.
FIG. 27 is a cross-sectional view of another embodiment taken along a B-B' region of FIG. 3.

### [Modes of the Invention]

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and replaced.

In addition, unless expressly otherwise defined and described, the terms used in the embodiments of the present disclosure (including technical and scientific terms) may be construed the same meaning as commonly understood by one of ordinary skill in the art to which this invention belongs, and the terms such as those defined in commonly used dictionaries may be interpreted as having a meaning that is consistent with their meaning in the context of the relevant art.

In addition, the terms used in the embodiments of the present disclosure are for describing the embodiments and are not intended to limit the present disclosure. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "connected" to another element, it may include not only when the element is directly "connected" to, "coupled" to, or "connected" to other elements, but also when the element is "connected", "coupled", or "connected" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

Hereinafter, a smart IC substrate, a smart IC module, and an IC card including the same according to an embodiment will be described with reference to the drawings.

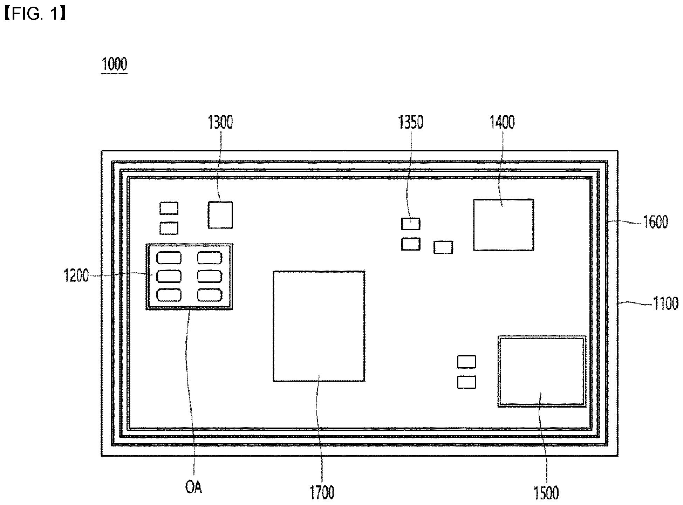

FIG. 1 is a top view of an IC card according to an embodiment.

Referring to FIG. 1, the IC card 1000 may include a card body 1100, a smart IC substrate 1200 accommodated in the card body 1100, a chip 1300, a micro controller unit (MCU) 1400, a connection circuit pattern 1350 electrically connecting the chip 1300 and the micro controller unit 1400, a fingerprint sensor 1500, an antenna 1600, and a battery 1700.

The smart IC substrate 1200 may be accommodated in the card body 1100. In detail, an opening OAfor accommodating the smart IC substrate 1200 is formed in the card body 2000, and the smart IC substrate 1200 may be inserted and adhered to the opening OA.

Accordingly, any one of one surface and the other surface of the smart IC substrate 1200 may be exposed to the outside of the IC card.

The IC card may include the fingerprint sensor 1500. The fingerprint sensor 1500 may recognize a user's fingerprint and match fingerprint information stored in the chip 1300.

That is, user's fingerprint information are stored in the chip 1300. The fingerprint recognized through the fingerprint sensor 1500 and the fingerprint information stored in the chip 1300 may be matched to compare with each other.

For example, when a user's finger is in contact with the fingerprint sensor 1500, power is supplied from the battery 1700 to the micro controller unit 1400. In addition, the fingerprint sensor 1500 supplied with the power by the micro controller unit 1400 may be driven.

Subsequently, the micro controller unit 1400 may receive the fingerprint information recognized through the fingerprint sensor 1500. In addition, an authentication process of the recognized fingerprint information may be performed.

Subsequently, when the recognized fingerprint information and the fingerprint information stored in the chip 1300 match, the smart IC substrate 1200 may be activated, and a function of the IC card may also be activated.

On the other hand, when the recognized fingerprint information and the fingerprint information stored in the chip 1300 do not match, the smart IC substrate 1200 may be deactivated, and the function of the IC card may be also deactivated.

However, the embodiment is not limited thereto, and the IC card may not include the fingerprint sensor 1500. The IC card may activate the function of the IC card without separate fingerprint authentication.

In addition, the IC card may include an antenna 1600. Accordingly, the IC smart card may operate as a contactless card. That is, information may be wirelessly transmitted/received to/from the server through the antenna even when the card and the card reader are not in contact with each other.

However, the embodiment is not limited thereto, the IC does not include the antenna 1600, and the IC card may operate as a contact card. That is, the IC is inserted into the card reader and may transmit and receive information to and from the server due to contact with a circuit board.

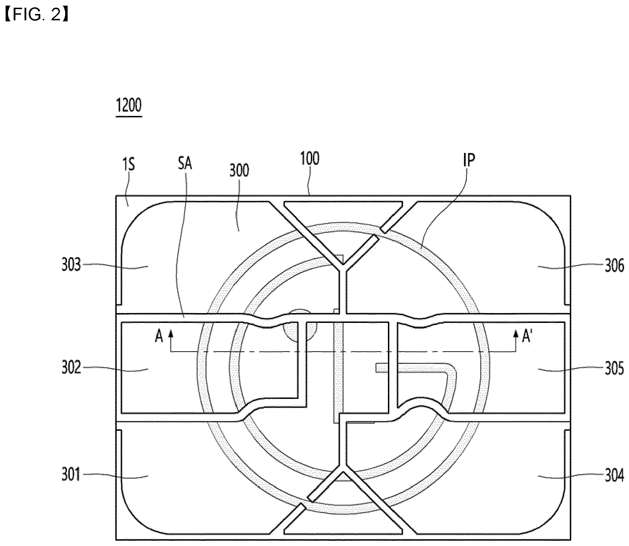

FIGS. 2 to 5 are top views of one surface and the other surface of a smart IC substrate according to an embodiment.

Referring to FIGS. 2 to 5, the smart IC substrate 1200 includes one surface and the other surface opposite to the one surface. A chip is mounted on the smart IC substrate 1200. Accordingly, a smart IC module may be provided. The one surface may be a contact side of the smart IC substrate 1200. In addition, the other surface may be a bonding side of the smart IC substrate 1200.

That is, the one surface may recognize information of the smart IC module through direct or indirect contact with the IC card. In addition, the other surface may be a surface on which a chip is mounted and adhered to the card body 2000.

The smart IC substrate 1200 includes a substrate 100 and a plurality of circuit patterns.

The substrate 100 may include a resin material. The substrate 100 may include a first surface 1S and a second surface 2S opposite to the first surface 1S. The first surface 1S may be one surface of the smart IC substrate 1200. That is, the first surface 1S may be defined as a surface corresponding to the contact side of the smart IC substrate 1200. Also, the second surface 2S may be defined as a surface corresponding to the bonding side of the smart IC substrate 1200.

The substrate 100 may include a prepreg including a glass fiber. Specifically, the substrate 100 may include an epoxy resin and a material in which a glass fiber and a silicon-based filler are dispersed in the epoxy resin.

In addition, the substrate 100 may be rigid or flexible. For example, the substrate 100 may include glass or plastic. In detail, the substrate 100 may include chemical-enhanced/semi-enhanced glass such as soda time glass or aluminosilicate glass, or may include polyimide (PI), polyethylene terephthalate (PET), propylene glycol (PPG), polycarbonate (PC), etc., or may include sapphire.

Also, the substrate 100 may include a photo isotropic film. For example, the substrate 100 may include a cyclic olefin copolymer (COC), a cyclic olefin polymer (COP), a photo isotropic polycarbonate (PC), a photo isotropic polymethyl methacrylate (PMMA), or the like.

In addition, the substrate 100 may be partially bent having a curved surface. That is, the substrate 100 may bent while partially having a flat surface and partially having a curved surface. In detail, an end of the substrate 100 may be bent having a curved surface or may be curved or bent having a surface including a random curvature.

Also, the substrate 100 may be a flexible substrate having a flexible characteristic. Also, the substrate 100 may be a curved or bent substrate.

Adhesive layers 210 and 220 are disposed on the first surface 1S and the second surface 2S. The adhesive layers 210 and 220 may be disposed on an entire surface of the first surface 1S and the second surface 2S. Specifically, the adhesive layers 210 and 220 may be disposed on the front surface of the first surface 1S and the second surface 2S, except for a region in which a via is formed.

The adhesive layers 210 and 220 may include a resin material. For example, the adhesive layers 210 and 220 may include at least one of an epoxy resin, an acrylic resin, and a polyimide resin. Also, in order to impart flexibility to the adhesive layers 210 and 220, the adhesive layers 210 and 220 may further include additives such as natural rubber, a plasticizer, a curing agent, and a flame retardant such as phosphorus.

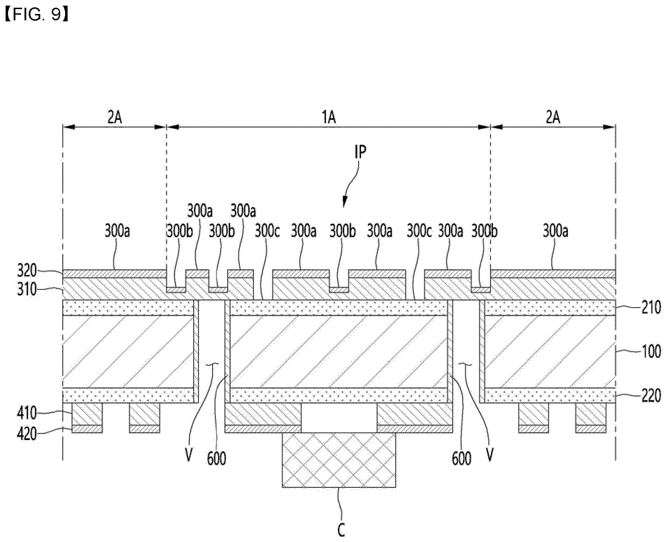

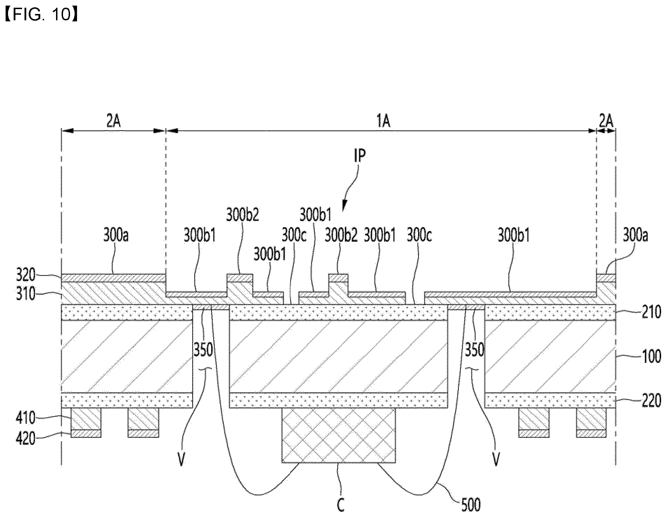

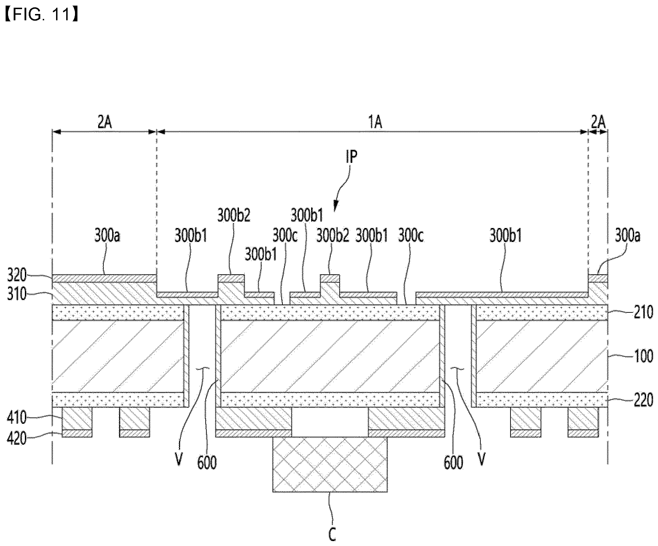

Referring to FIGS. 2 to 11, circuit patterns 300 and 400 are disposed on the substrate 100. Specifically, circuit patterns may be disposed on the first surface 1S and the second surface 2S, respectively. For example, a first circuit pattern 300 may be disposed on the first surface 1S, and a second circuit pattern 400 may be disposed on the second surface 2S. That is, the first circuit pattern 300 may be disposed on a contact side of the smart IC substrate. Also, the second circuit pattern 400 may be disposed on a bonding side of the smart IC substrate.

Referring to FIGS. 2, 3, and 8 to 11, the first circuit pattern 300 may be disposed on the first adhesive layer 210 disposed on the substrate 100.

The first circuit pattern 300 may include a first metal layer 310 and a second metal layer 320. Specifically, the first circuit pattern 300 may include a first metal layer 310 disposed on the first adhesive layer 210 and a second metal layer 320 disposed on the first metal layer 310.

The first metal layer 310 includes a metal material. Specifically, the first metal layer 310 may include a metal material having high electrical conductivity. For example, the first metal layer 310 may include at least one of gold (Au), silver (Ag), platinum (Pt), titanium (Ti), tin (Sn), copper (Cu), and zinc (Zn). Preferably, the first metal layer 310 may include copper (Cu).

The second metal layer 320 may be disposed on the first metal layer 310. Accordingly, the second metal layer 320 may protect the first metal layer 310. That is, the second metal layer 320 may prevent corrosion of the first metal layer 310. That is, the second metal layer 320 may be a protective layer that protects the first circuit pattern 300.

The second metal layer 320 may include nickel-gold (Ni-Au) or nickel-palladium (Ni-Pd). However, the embodiment is not limited thereto. For example, the second metal layer 320 may form a nickel (Ni) layer on the first metal layer 310, and then a gold (Au) layer may be disposed on the nickel layer. Alternatively, the second metal layer 320 may be formed by forming a nickel layer on the first metal layer 310 and then disposing a palladium layer on the nickel layer. In this case, a nickel-gold alloy layer may be formed between the nickel layer and the gold layer. Also, a nickel-palladium alloy layer may be formed between the nickel layer and the palladium layer.

The first metal layer 310, the second metal layer 320, and the first adhesive layer 210 may have different thicknesses.

Specifically, a thickness of the first metal layer 310 may be greater than a thickness of the second metal layer 320 and a thickness of the first adhesive layer 210. Also, a thickness of the first adhesive layer 210 may be greater than a thickness of the second metal layer 320.

For example, the first metal layer 310 may have a thickness of 35 to 70 µm, the second metal layer 320 may have a thickness of 1 to 3 µm, and the first active layer 210 may have a thickness of 15 to 30 µm.

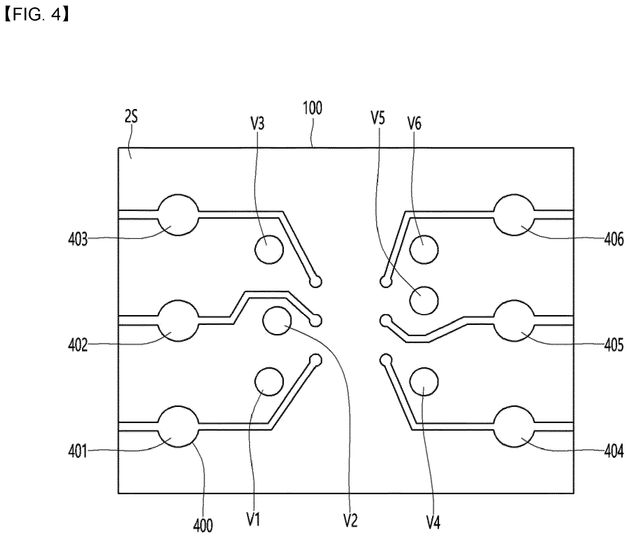

Referring to FIGS. 4 to 11, the second circuit pattern 400 is disposed on the second active layer 210 disposed on the substrate 100.

The second circuit pattern 400 may include a third metal layer 410 and a fourth metal layer 420. Specifically, the second circuit pattern 400 may include a third metal layer 410 disposed on the second adhesive layer 220 and a fourth metal layer 420 disposed on the third metal layer 410.

The third metal layer 410 includes a metal material. Specifically, the third metal layer 410 may include a metal material having high electrical conductivity. For example, the third metal layer 330 may include at least one of gold (Au), silver (Ag), platinum (Pt), titanium (Ti), tin (Sn), copper (Cu), and zinc (Zn). Preferably, the third metal layer 330 may include copper (Cu).

The fourth metal layer 420 may be disposed on the third metal layer 410. The fourth metal layer 420 may protect the third metal layer 410. That is, the fourth metal layer 420 may prevent corrosion of the third metal layer 410. That is, the fourth metal layer 420 may be a protective layer that protects the second circuit pattern 400.

The fourth metal layer 420 may include the same or different metal materials among metal materials included in the second metal layer 320 described above.

The third metal layer 410, the fourth metal layer 420, and the second adhesive layer 220 may have different thicknesses.

Specifically, a thickness of the third metal layer 410 may be greater than a thickness of the fourth metal layer 420 and a thickness of the second adhesive layer 220. Also, a thickness of the second adhesive layer 220 may be greater than a thickness of the fourth metal layer 420.

For example, the thickness of the third metal layer 410 may be 35 to 70 µm. Also, the thickness of the fourth metal layer 420 may be 3 to 8 µm. Also, the thickness of the second adhesive layer 220 may be 15 to 30 µm.

The thickness of the fourth metal layer 420 may be greater than the thickness of the second metal layer 320. That is, the fourth metal layer 420 disposed on the bonding side of the smart IC substrate 1200 may be greater than the thickness of the second metal layer 320.

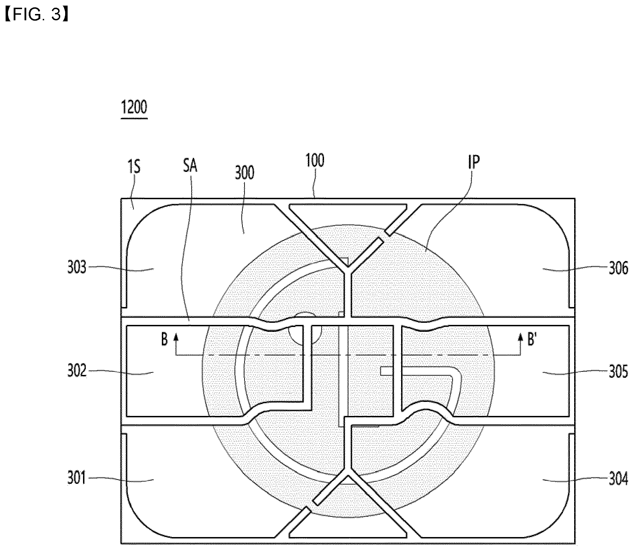

Referring to FIGS. 2 and 3, the first circuit pattern 300 includes a plurality of circuit patterns. Specifically, the first circuit pattern 300 may include a plurality of circuit patterns spaced apart from each other.

Referring to FIGS. 2 and 3, the first circuit pattern 300 may include a first-first circuit pattern 301, a first-second circuit pattern 302, a first-third circuit pattern 303, a first-fourth circuit pattern 304, a first-fifth circuit pattern 305, and a first-sixth circuit pattern 306.

In FIG. 2 and FIG. 3, the first-first circuit pattern 301, the first-second circuit pattern 302, the first-third circuit pattern 303, the first-fourth circuit pattern 304, the first-fifth circuit pattern 305, and the first-sixth circuit pattern 306 are illustrated, but an embodiment is not limited thereto. For example, the first circuit pattern 300 may include less than six circuit patterns or more than six circuit patterns.

The first-first circuit pattern 301, the first-second circuit pattern 302, the first-third circuit pattern 303, the first-fourth circuit pattern 304, the first-fifth circuit pattern 305, and the first-sixth circuit pattern 306 may be spaced apart from each other.

In detail, space regions SA in which a circuit pattern is not disposed are formed between the first-first circuit pattern 301, the first-second circuit pattern 302, the first-third circuit pattern 303, the first-fourth circuit pattern 304, the first-fifth circuit pattern 305, and the first-sixth circuit pattern 306. By the space regions SA, the first-first circuit pattern 301, the first-second circuit pattern 302, the first-third circuit pattern 303, the first-fourth circuit pattern 304, the first-fifth circuit pattern 305, and the first-sixth circuit pattern 306 may be spaced apart from each other. That is, the spacer region SA may be a spacing between the first-first circuit pattern 301, the first-second circuit pattern 302, the first-third circuit pattern 303, the first-fourth circuit pattern 304, the first-fifth circuit pattern 305, and the first-sixth circuit pattern 306.

The spacer region SA may have a predetermined size. For example, the spacer region SA may be in a range of 100 µm to 250 µm.

Accordingly, the first-first circuit pattern 301, the first-second circuit pattern 302, the first-third circuit pattern 303, the first-fourth circuit pattern 304, the first-fifth circuit pattern 305, and the first-sixth circuit pattern 306 are not electrically connected on the first surface 1S of the substrate 100.

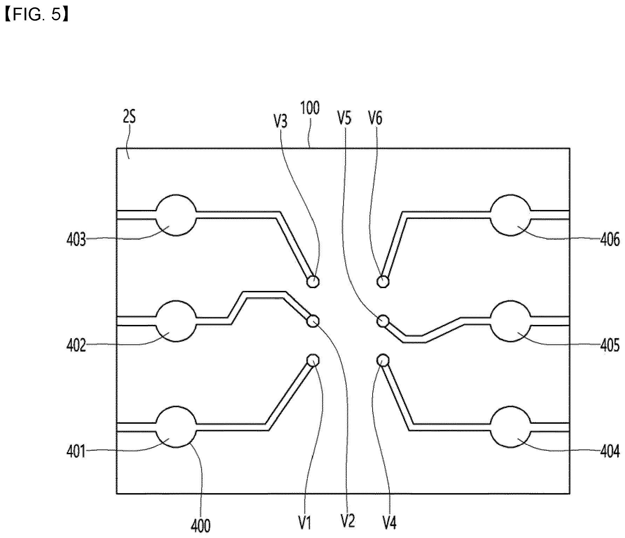

In addition, referring to FIGS. 4 and 5, the second circuit pattern 400 may include a second-first circuit pattern 401, a second-second circuit pattern 402, a second-third circuit pattern 403, a second-fourth circuit pattern 404, a second-fifth circuit pattern 405, and a second-sixth circuit pattern 406.

In FIGS. 4 and 5, the second-first circuit pattern 401, the second-second circuit pattern 402, the second-third circuit pattern 403, the second-fourth circuit pattern 404, the second-fifth circuit pattern 405, and the second-sixth circuit pattern 406 are illustrated, but an embodiment is not limited thereto. For example, the second circuit pattern 400 may include less than six circuit patterns or more than six circuit patterns.

The second-first circuit pattern 401, the second-second circuit pattern 402, the second-third circuit pattern 403, the second-fourth circuit pattern 404, the second-fifth circuit pattern 405, and the second-sixth circuit pattern 406 may be spaced apart from each other.

Referring to FIGS. 4 and 5, a chip mounting region may be formed on the second-first circuit pattern 401, the second-second circuit pattern 402, the second-third circuit pattern 403, the second-fourth circuit pattern 404, the second-fifth circuit pattern 405, and the second-sixth circuit pattern 406 disposed on the second surface 2S of the substrate 100.

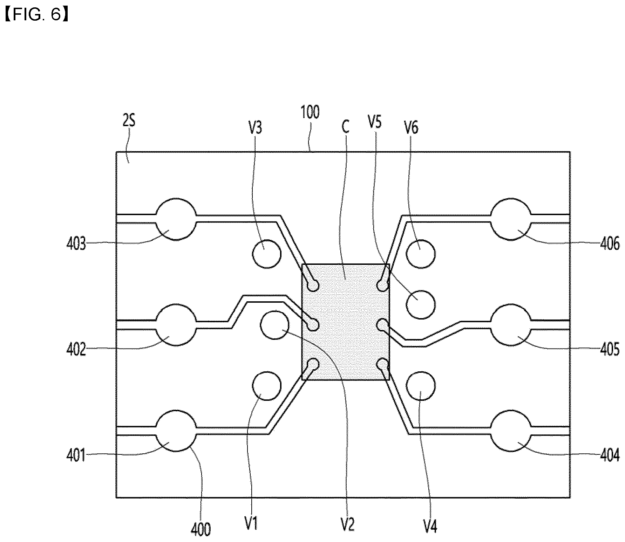

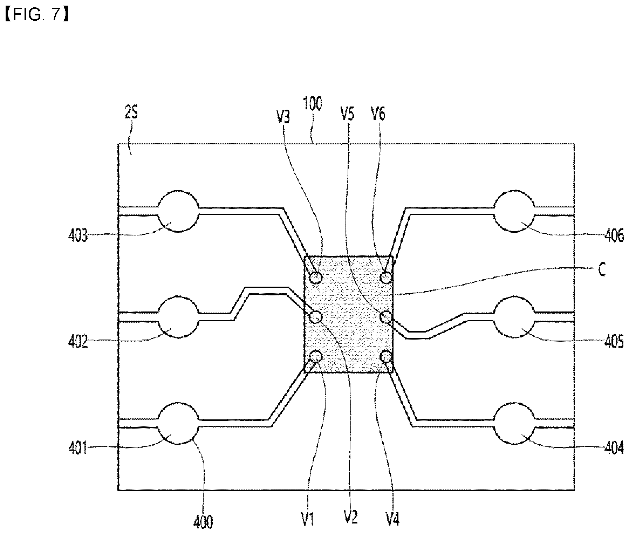

Referring to FIGS. 6 and 7, a chip C electrically connected to the first circuit pattern 300 and the second circuit pattern 400 is disposed in the chip mounting region. Accordingly, the smart IC module may be formed.

The chip C may be disposed on the second circuit pattern 400 and may be connected to the second circuit pattern 400. That is, the chip C is in direct contact with the second circuit pattern 400. Accordingly, the chip C may be electrically connected to the second circuit pattern 400.

Also, the chip C may be connected to the first circuit pattern 300. At least one via hole may be formed to connect the chip C to the first circuit pattern 300.

For example, a plurality of via holes passing through the first surface 1S and the second surface 2S may be formed in the substrate 100.

Referring to FIGS. 4 and 6, a plurality of via holes may be formed in the substrate 100. In detail, a plurality of via holes corresponding to each of the first circuit patterns 300 may be formed in the substrate 100.

Specifically, the first via hole V1 may be formed in a region overlapping the first-first circuit pattern 301 in a thickness direction of the substrate 100. In addition, the second via hole V2 may be formed in a region overlapping the first-second circuit pattern 302 in the thickness direction of the substrate 100. In addition, the third via hole V3 may be formed in a region overlapping the first-third circuit pattern 303 in the thickness direction of the substrate 100. In addition, the fourth via hole V4 may be formed in a region overlapping the first-fourth circuit pattern 304 in the thickness direction of the substrate 100. In addition, the fifth via hole V5 may be formed in a region overlapping the first-fifth circuit pattern 305 in the thickness direction of the substrate 100. In addition, a sixth via hole V6 may be formed in a region overlapping the first-sixth circuit pattern 306 in the thickness direction of the substrate 100.

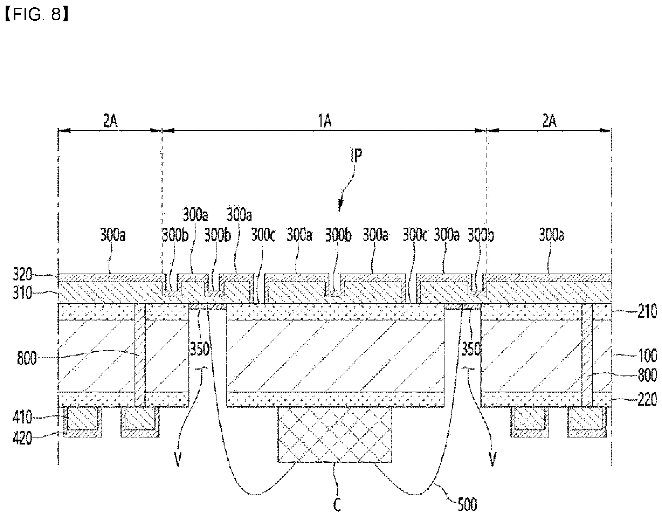

Referring to FIGS. 6 and 8, the chip C and the first circuit pattern 300 may be connected by a wire bonding. That is, the chip C and the first circuit pattern may be electrically connected through a plurality of wires 500 passing through the via hole.

A pad part 350 for wire bonding may be disposed on the first circuit pattern 300.

Also, referring to FIG. 8, the first circuit pattern 300 and the second circuit pattern 400 may be electrically connected through the conductive layer 800 inside the via hole passing through the substrate 100.

Alternatively, referring to FIGS. 5, 7, and 9, a plurality of via holes may be formed in the substrate 100. In detail, a plurality of via holes corresponding to each of the first circuit patterns 300 may be formed in the substrate 100.

Specifically, the first via hole V1 may be formed in a region overlapping the first-first circuit pattern 301 in a thickness direction of the substrate 100. In addition, the second via hole V2 may be formed in a region overlapping the first-second circuit pattern 302 in the thickness direction of the substrate 100. In addition, the third via hole V3 may be formed in a region overlapping the first-third circuit pattern 303 in the thickness direction of the substrate 100. In addition, the fourth via hole V4 may be formed in a region overlapping the first-fourth circuit pattern 304 in the thickness direction of the substrate 100. In addition, the fifth via hole V5 may be formed in a region overlapping the first-fifth circuit pattern 305 in the thickness direction of the substrate 100. In addition, a sixth via hole V6 may be formed in a region overlapping the first-sixth circuit pattern 306 in the thickness direction of the substrate 100.

Referring to FIGS. 5, 7, and 9, a plating layer 600 may be disposed on an inner surface of the first via hole V1, the second via hole V2, the third via hole V3, the fourth via hole V4, the fifth via hole V5, and the sixth via hole V6.

The plating layer 600 may be connected to the first circuit pattern 300 and the second circuit pattern 400. Accordingly, the chip C may be electrically connected to the first circuit pattern 300 and the second circuit pattern 400.

Meanwhile, the smart IC substrate 1200 may include an identification pattern IP capable of identifying information of the IC card. Specifically, the identification pattern IP may be disposed on the first surface 1S of the substrate 100. More specifically, the identification pattern IP may be disposed on the contact side of the smart IC substrate 1200. For example, a first region 1A in which the identification pattern IP is disposed and a second region 2A other than the first region 1A may be defined in the substrate 100. Also, the identification pattern IP may be disposed in the first region 1A.

Accordingly, the user may identify the information of the IC card through the contact side exposed to the outside of the IC card.

The identification pattern IP may be formed by the first circuit pattern 300. Specifically, the identification pattern IP may be formed by partially etching the first circuit pattern 300. That is, the identification pattern IP may be a part of the first circuit pattern 300. That is, the identification pattern IP may be a partial region of the first circuit pattern 300.

The identification pattern IP may be formed by various methods. Specifically, the identification pattern IP may be formed in various shapes according to an etching method of the first circuit pattern 300.

First, the identification pattern of the smart IC substrate according to a first embodiment will be described with reference to FIGS. 2, 6 to 9.

Referring to FIGS. 2, 6 to 9, the first circuit pattern 300 may be defined as a first circuit pattern part 300a, a second circuit pattern part 300b, and a third circuit pattern part 300c.

The thicknesses of the first circuit pattern part 300a, the second circuit pattern part 300b, and the third circuit pattern part 300c may be different from each other. For example, the thickness of the first circuit pattern part 300a may be greater than the thicknesses of the second circuit pattern part 300b and the third circuit pattern part 300c. Also, the thickness of the second circuit pattern part 300b may be greater than the thickness of the third circuit pattern part 300c.

The first circuit pattern part 300a may include the first metal layer 310 and the second metal layer 320. The first circuit pattern part 300a may be a region in which the first circuit pattern 300 is not etched.

The first circuit pattern part 300a may be disposed in at least one of the first region 1A and the second region 2A. Specifically, the first circuit pattern part 300a may be disposed in both the first region 1A and the second region 2A.

The second circuit pattern part 300b may include the first metal layer 310 and the second metal layer 320.

The second circuit pattern part 300b may be disposed in the first region 1A. Specifically, the second circuit pattern part 300b may be disposed only in the first region 1A.

Also, thicknesses of the first metal layer 310 of the first circuit pattern part 300a and the first metal layer 310 of the second circuit pattern part 300b may be different. Specifically, the first metal layer 310 of the first circuit pattern part 300a may be greater than the thickness of the first metal layer 310 of the second circuit pattern part 300b.

Accordingly, the first circuit pattern part 300a and the second circuit pattern part 300b may have a thickness difference due to a thickness difference between the first metal layer 310.

In detail, the thickness of the second circuit pattern part 300b may be 10% to 50% of the thickness of the first circuit pattern part 300a. Forming the thickness of the second circuit pattern part 300b to exceed 50% of the thickness of the first circuit pattern part 300a may be difficult to implement in an etching process. Also, when the thickness of the second circuit pattern part 300b is less than 10% of the thickness of the first circuit pattern part 300a, the thickness of the first metal layer 310 of the second circuit pattern part 300b may be reduced, thereby reducing conductivity.

Also, the difference in thickness between the first circuit pattern part 300a and the second circuit pattern part 300b may be 3.5 µm to 18 µm. Forming the difference in thickness between the first circuit pattern part 300a and the second circuit pattern part 300b to be less than 3.5 µm may be difficult to implement in an etching process. Also, when the difference in thickness between the first circuit pattern part 300a and the second circuit pattern part 300b exceeds 18 µm, the thickness of the first metal layer 310 of the second circuit pattern part 300b may be reduced, thereby reducing conductivity.

In addition, the width of the second circuit pattern part 300b may be similar to or greater than a width of the space region SA.

The second circuit pattern part 300b may be a region in which the first circuit pattern 300 is etched. Specifically, the second circuit pattern part 300b may be a region in which the first metal layer 310 of the first circuit pattern 300 is partially etched. The second circuit pattern part 300b may correspond to the identification pattern IP. That is, a pattern including texts, symbols, or numbers may be formed on the smart IC substrate 1200 by the second circuit pattern part 300b. That is, an identification pattern IP including texts, symbols, or numbers of an engraved shape may be formed on the smart IC substrate 1200. That is, an identification pattern IP including texts, symbols, or numbers of an engraved shape may be formed on the smart IC substrate 1200.

The second circuit pattern part 300b may be disposed at a position overlapping the via holes V1, V2, V3, V4, V5, and V6. Specifically, the second circuit pattern part 300b may be disposed at a position overlapping the via holes V1, V2, V3, V4, V5, and V6 in a thickness direction of the substrate 120.

Alternatively, the second circuit pattern part 300b may be disposed at a position that does not overlap the via holes V1, V2, V3, V4, V5, and V6. Specifically, the second circuit pattern part 300b may be disposed at a position that does not overlap the via holes V1, V2, V3, V4, V5, and V6 in a thickness direction of the substrate 100.

The second circuit pattern part 300b may be disposed in at least one of a position that overlaps or a position that does not overlap the via holes V1, V2, V3, V4, V5, and V6 in the thickness direction of the substrate 100. The second circuit pattern part 300b may be disposed in a position that overlaps and a position that does not overlap the via holes V1, V2, V3, V4, V5, and V6 in the thickness direction of the substrate 100. In other words, the position of the second circuit pattern part 300b may be disposed regardless of the positions of the via holes V1, V2, V3, V4, V5, and V6. That is, the identification pattern IP formed by the second circuit pattern part 300b may be disposed regardless of the positions of the via holes V1, V2, V3, V4, V5, and V6.

Therefore, when the identification pattern is formed on the IC card, identification patterns may be formed at various positions regardless of the position of the via hole formed in the substrate. Accordingly, the degree of design freedom of the identification pattern may be improved.

The first circuit pattern part 300a and the second circuit pattern part 300b may be recognized as different colors. Specifically, the first circuit pattern part 300a and the second circuit pattern part 300b may have different thicknesses due to the difference in thickness of the first metal layer 310. Accordingly, a contrast difference occurs between the first circuit pattern part 300a and the second circuit pattern part 300b due to the thickness difference. Accordingly, a user can recognize the first circuit pattern part 300a and the second circuit pattern part 300b as different colors from the outside due to the contrast difference.

Therefore, since the first surface 1S exposed to the outside of the IC card may have various colors, the degree of design freedom may be improved. Also, since the first circuit pattern part 300a and the second circuit pattern part 300b are distinguished by a difference in thickness or color, the user can easily identify the identification pattern of the IC card from the outside.

The third circuit pattern part 300c may be a region in which the first circuit pattern 300 is etched. Specifically, the third circuit pattern part 300c may be a region in which the first circuit pattern 300 is completely or almost etched. That is, the first circuit pattern 300 may not remain in the third circuit pattern part 300c or may remain in a small amount. That is, the thickness of the first circuit pattern 300 in the third circuit pattern part 300c may be zero or close to zero.

Here, the meaning that the third circuit pattern part 300c remains may mean that the first circuit pattern 300 is not connected to adjacent circuit patterns on the first surface 1S of the substrate 100 after etching. Additionally, it means that it remains in an amount such that a plating layer is not formed by the plating process.

The third circuit pattern part 300c may correspond to the space region SA. That is, the third circuit pattern part 300c may be the space region SA. That is, the first circuit pattern 300 may be divided into a plurality of circuit patterns by the third circuit pattern part 300c.

Hereinafter, the identification pattern of the smart IC substrate according to the second embodiment will be described with reference to FIGS. 3, 6, 7, 10, and 11.

Referring to FIGS. 3, 6, 7, 10, and 11, the first circuit pattern 300 may be defined as a first circuit pattern part 300a, a second-first circuit pattern part 300b1, a second-second circuit pattern part 300b2, and a third circuit pattern part 300c.

Thicknesses of the first circuit pattern part 300a, the second-first circuit pattern part 300b1, the second-second circuit pattern part 300b2, and the third circuit pattern part 300c may be different from each other. For example, the thickness of the first circuit pattern part 300a may be greater than the thicknesses of the second-first circuit pattern part 300b1 and the third circuit pattern part 300c.

Also, the thickness of the second-first circuit pattern part 300b1 may be greater than the thickness of the third circuit pattern part 300c. Also, the thicknesses of the first circuit pattern part 300a and the second-second circuit pattern part 300b2 may be the same or may be the same within a tolerance range. Also, the thickness of the second-second circuit pattern part 300b2 may be greater than the thickness of the second-first circuit pattern part 300b1.

The first circuit pattern part 300a may include the first metal layer 310 and the second metal layer 320. The first circuit pattern part 300a may be a region in which the first circuit pattern 300 is not etched.

The first circuit pattern part 300a may be disposed in the second region 2A. Specifically, the first circuit pattern part 300a may be disposed only in the second region 2A.

The second-first circuit pattern part 300b1 may include the first metal layer 310 and the second metal layer 320.

The second-first circuit pattern part 300b1 may be disposed in the first region 1A. Specifically, the second-first circuit pattern part 300b1 may be disposed only in the first region 1A.

Also, thicknesses of the first metal layer 310 of the first circuit pattern part 300a and the first metal layer 310 of the second-first circuit pattern part 300b1 may be different from each other. Specifically, the first metal layer 310 of the first circuit pattern part 300a may be greater than the thickness of the first metal layer 310 of the second-first circuit pattern part 300b1.

Accordingly, the first circuit pattern part 300a and the second-first circuit pattern part 300b1 may have different thicknesses due to the difference in thickness of the first metal layer 310.

Specifically, the thickness of the second-first circuit pattern part 300b1 may be 10% to 50% of the thickness of the first circuit pattern part 300a. When the thickness of the second-first circuit pattern part 300b1 exceeds 50% of the thickness of the first circuit pattern part 300a, it may be difficult to implement in the etching process. Also, when the thickness of the second-first circuit pattern part 300b1 is less than 10% of the thickness of the first circuit pattern part 300a, the thickness of the first metal layer 310 of the second-first circuit pattern part 300b1 may be reduced, thereby reducing conductivity.

Also, the difference in thickness between the first circuit pattern part 300a and the second-first circuit pattern part 300b1 may be 3.5 µm to 18 µm. When the difference in thickness between the first circuit pattern part 300a and the second-first circuit pattern part 300b1 is less than 3.5 µm, it may be difficult to implement in the etching process. Also, when the difference in thickness between the first circuit pattern part 300a and the second-first circuit pattern part 300b1 exceeds 18 µm, the thickness of the first metal layer 310 of the second-first circuit pattern part 300b1 may be reduced, thereby reducing conductivity.

In addition, a width of the second-first circuit pattern part 300b1 may be similar to or greater than a width of the space region SA.

The second-first circuit pattern part 300b1 may be a region in which the first circuit pattern 300 is etched. Specifically, the second-first circuit pattern part 300b1 may be a region in which the first metal layer 310 of the first circuit pattern 300 is partially etched.

The second-first circuit pattern part 300b1 may be disposed at a position overlapping the via holes V1, V2, V3, V4, V5, and V6. Specifically, the second-first circuit pattern part 300b1 may be disposed at a position overlapping the via holes V1, V2, V3, V4, V5, and V6 in a thickness direction of the substrate 100.

Alternatively, the second-first circuit pattern part 300b1 may be disposed at a position that does not overlap the via holes V1, V2, V3, V4, V5, and V6. Specifically, the second-first circuit pattern part 300b1 may be disposed at a position that does not overlap the via holes V1, V2, V3, V4, V5, and V6 in a thickness direction of the substrate 100.

That is, the second-first circuit pattern part 300b1 may be disposed at both a position that does not overlap the via holes V1, V2, V3, V4, V5, and V6 and a position that does not overlap the via holes V1, V2, V3, V4, V5, and V6 in a thickness direction of the substrate 100. In other words, the second-first circuit pattern part 300b1 may be disposed regardless of the positions of the via holes V1, V2, V3, V4, V5, and V6.

The first circuit pattern part 300a and the second-first circuit pattern part 300b1 may be recognized as different colors. Specifically, the first circuit pattern part 300a and the second-first circuit pattern part 300b1 may have different thicknesses due to the difference in thickness of the first metal layer 310. Accordingly, the difference in contrast occurs between the first circuit pattern part 300a and the second-first circuit pattern part 300b1 due to the difference in thickness. Accordingly, a user may recognize the first circuit pattern part 300a and the second-first circuit pattern part 300b1 as different colors from the outside due to the difference in contrast.

Therefore, since the first surface 1S exposed to the outside of the IC card may have various colors, the degree of design freedom may be improved. Also, since the first circuit pattern part 300a and the second-first circuit pattern part 300b1 are distinguished by a difference in thickness or color, the user can easily identify the identification pattern of the IC card from the outside.

The second-second circuit pattern part 300b2 may include the first metal layer 310 and the second metal layer 320. The second-second circuit pattern part 300b2 may be a region in which the first circuit pattern 300 is not etched.

The second-second circuit pattern part 300b2 may be disposed in the first region 1A. Specifically, the second-second circuit pattern part 300b2 may be disposed only in the first region 1A.

That is, the second-first circuit pattern part 300b1 and the second-second circuit pattern part 300b2 may be disposed in the first region 1A in which the identification pattern IP is formed.

Accordingly, an identification pattern IP may be formed in the first region 1A by the second-first circuit pattern part 300b1 and the second-second circuit pattern part 300b2.

In detail, an identification pattern IP may be formed in the first region 1A by the second-first circuit pattern part 300b1 and the second-second circuit pattern part 300b2 of the first circuit pattern 300 having different thicknesses.

That is, a pattern including texts, symbols, or numbers may be formed on the smart IC substrate 1200 by the second-first circuit pattern part 300b1 and the second-second circuit pattern part 300b2. That is, an identification pattern IP including embossed texts, symbols, or numbers may be formed on the smart IC substrate 1200.

The color of the second-first circuit pattern part 300b1 may be recognized as a different color of at least one of the first circuit pattern part 300a and the second-second circuit pattern part 300b2.

For example, the second-first circuit pattern part 300b1 and the second-second circuit pattern part 300b2 may be recognized as different colors. Specifically, the first circuit pattern part 300a and the second-first circuit pattern part 300b1 may have different thicknesses due to the difference in thickness of the first metal layer 310. Accordingly, the difference in contrast occurs between the first circuit pattern part 300a and the second-first circuit pattern part 300b1 due to the difference in thickness. Accordingly, the user can recognize the first circuit pattern part 300a and the second-first circuit pattern part 300b1 as different colors from the outside due to the difference in contrast.

Therefore, since the second-first circuit pattern part 300b1 and the second-second circuit pattern part 300b2 are distinguished by a difference in thickness or color, the user can easily identify the identification pattern of the IC card from the outside.

In addition, the user can recognize the identification pattern IP as two or more colors, thereby improving the degree of freedom in external design of the identification pattern.

In addition, the second-first circuit pattern part 300b1 may be disposed in the first region 1A regardless of the positions of the via holes V1, V2, V3, V4, V5, and V6. Accordingly, the identification pattern IP formed by the second-first circuit pattern part 300b1 and the second-second circuit pattern part 300b2 may also be disposed regardless of the positions of the via holes V1, V2, V3, V4, V5, and V6.

Therefore, when the identification pattern is formed on the IC card, identification patterns may be formed at various positions regardless of the position of the via hole formed in the substrate. Accordingly, the degree of design freedom of the identification pattern may be improved.

The third circuit pattern part 300c may be a region in which the first circuit pattern 300 is etched. Specifically, the third circuit pattern part 300c may be a region in which the first circuit pattern 300 is completely or almost etched. That is, the first circuit pattern 300 may not remain in the third circuit pattern part 300c or may remain in a small amount. That is, the thickness of the first circuit pattern 300 disposed on the third circuit pattern part 300c may be zero or close to zero.

Here, the meaning that the third circuit pattern part 300c remains means that the first circuit pattern 300 is not connected to adjacent circuit patterns on the first surface 1S of the substrate 100 after etching. Additionally, it means that it remains in an amount such that a plating layer is not formed by the plating process.

The third circuit pattern part 300c may correspond to the space region SA. That is, the third circuit pattern part 300c may be the space region SA. That is, the first circuit pattern 300 may be divided into a plurality of circuit patterns by the third circuit pattern part 300c.

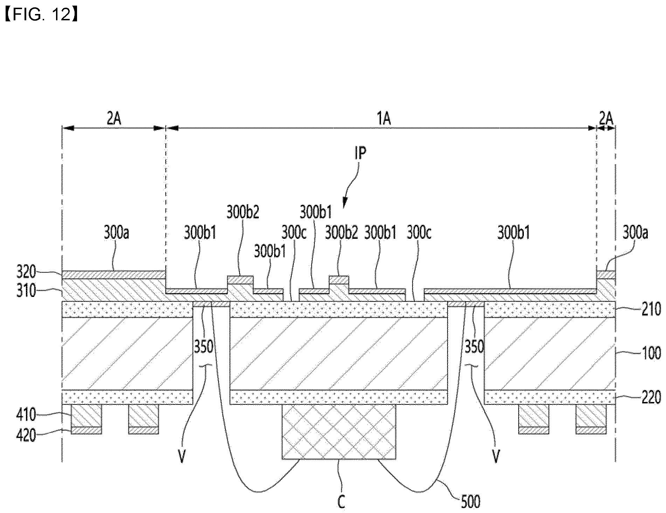

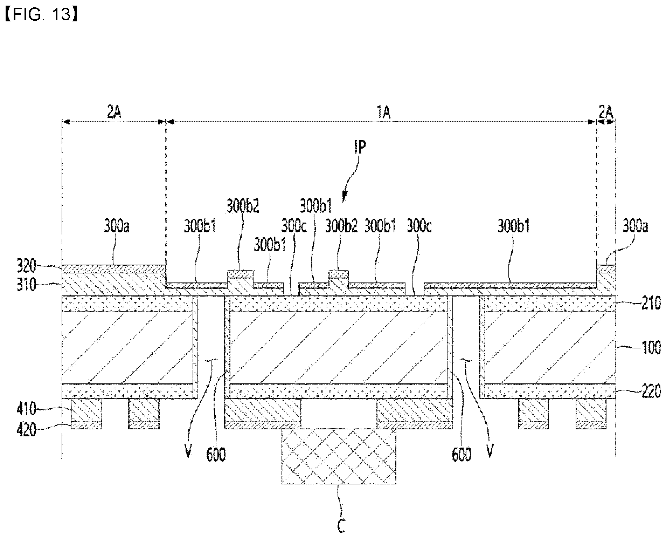

Hereinafter, the identification pattern of the smart IC substrate according to the third embodiment will be described with reference to FIGS. 3, 6, 7, 12, and 13.

Referring to FIGS. 3, 6, 7, 12, and 13, the first circuit pattern 300 may include a first circuit pattern part 300a, a second-first circuit pattern part 300b1, a second-second circuit pattern part 300b2, and a third circuit pattern part 300c.

The thicknesses of the first circuit pattern part 300a, the second-first circuit pattern part 300b1, the second-second circuit pattern part 300b2, and the third circuit pattern part 300c may be different from each other. For example, the thickness of the first circuit pattern part 300a may be greater than the thicknesses of the second-first circuit pattern part 300b1, the second-second circuit pattern part 300b2, and the third circuit pattern part 300c.

In addition, the thickness of the second-second circuit pattern part 300b2 may be greater than the thickness of the second-first circuit pattern part 300b1 and the third circuit pattern part 300c.

In addition, the thickness of the second-first circuit pattern part 300b1 may be greater than the thickness of the third circuit pattern part 300c.

The first circuit pattern part 300a may include the first metal layer 310 and the second metal layer 320. The first circuit pattern part 300a may be a region in which the first circuit pattern 300 is not etched.

The first circuit pattern part 300a may be disposed in the second region 2A. Specifically, the first circuit pattern part 300a may be disposed only in the second region 2A.

The second-first circuit pattern part 300b1 may include the first metal layer 310 and the second metal layer 320.

The second-first circuit pattern part 300b1 may be disposed in the first region 1A. Specifically, the second-first circuit pattern part 300b1 may be disposed only in the first region 1A.

Also, thicknesses of the first metal layer 310 of the first circuit pattern part 300a and the first metal layer 310 of the second-first circuit pattern part 300b1 may be different from each other. Specifically, the first metal layer 310 of the first circuit pattern part 300a may be greater than the thickness of the first metal layer 310 of the second-first circuit pattern part 300b1.

Accordingly, the first circuit pattern part 300a and the second-first circuit pattern part 300b1 may have different thicknesses according to the difference in thickness of the first metal layer 310.

Specifically, the thickness of the second-first circuit pattern part 300b1 may be 10% to 50% of the thickness of the first circuit pattern part 300a. When the thickness of the second-first circuit pattern part 300b1 exceeds 50% of the thickness of the first circuit pattern part 300a, it may be difficult to implement in the etching process. Also, when the thickness of the second-first circuit pattern part 300b1 is less than 10% of the thickness of the first circuit pattern part 300a, the thickness of the first metal layer 310 of the second-first circuit pattern part 300b1 may be reduced, thereby reducing conductivity.

Also, the difference in thickness between the first circuit pattern part 300a and the second-first circuit pattern part 300b may be 3.5 µm to 18 µm. When the difference in thickness between the first circuit pattern part 300a and the second-first circuit pattern part 300b1 is less than 3.5 µm, it may be difficult to implement in the etching process. Also, when the difference in thickness between the first circuit pattern part 300a and the second-first circuit pattern part 300b1 exceeds 18 µm, the thickness of the first metal layer 310 of the second-first circuit pattern part 300b1 may be reduced, thereby reducing conductivity.

In addition, the width of the second-first circuit pattern part 300b1 may be similar to or greater than a width of the space region SA.

The second-first circuit pattern part 300b1 may be a region in which the first circuit pattern 300 is etched. Specifically, the second-first circuit pattern part 300b1 may be a region in which the first metal layer 310 of the first circuit pattern 300 is partially etched.

The second-first circuit pattern part 300b1 may be disposed at a position overlapping the via holes V1, V2, V3, V4, V5, and V6. Specifically, the second-first circuit pattern part 300b1 may be disposed at a position overlapping the via holes V1, V2, V3, V4, V5, and V6 in a thickness direction of the substrate 100.

Alternatively, the second-first circuit pattern part 300b1 may be disposed at a position that does not overlap the via holes V1, V2, V3, V4, V5, and V6. Specifically, the second-first circuit pattern part 300b1 may be disposed at a position that does not overlap the via holes V1, V2, V3, V4, V5, and V6 in a thickness direction of the substrate 100.

That is, the second-first circuit pattern part 300b1 may be disposed at both a position that does not overlap the via holes V1, V2, V3, V4, V5, and V6 and a position that does not overlap the via holes V1, V2, V3, V4, V5, and V6 in a thickness direction of the substrate 100. In other words, the second-first circuit pattern part 300b1 may be disposed regardless of the positions of the via holes V1, V2, V3, V4, V5, and V6.

The first circuit pattern part 300a and the second-first circuit pattern part 300b1 may be recognized as different colors. Specifically, the first circuit pattern part 300a and the second-first circuit pattern part 300b1 may have different thicknesses due to the difference in thickness of the first metal layer 310. Accordingly, the difference in contrast occurs between the first circuit pattern part 300a and the second-first circuit pattern part 300b1 due to the difference in thickness. Accordingly, a user can recognize the first circuit pattern part 300a and the second-first circuit pattern part 300b1 as different colors from the outside due to the difference in contrast.

Accordingly, the degree of design freedom of the first surface 1S exposed to the outside of the IC card may be improved.

The second-second circuit pattern part 300b2 may include the first metal layer 310 and the second metal layer 320.

For example, the second-second circuit pattern part 300b2 may be a region in which the first circuit pattern 300 is etched. Specifically, the second-second circuit pattern part 300b2 may be a region in which the first metal layer 310 of the first circuit pattern 300 is partially etched.

The thickness of the first metal layer 310 of the second-second circuit pattern part 300b2 may be greater than the thickness of the first metal layer 310 of the second-first circuit pattern part 300b1. That is, the thickness of the first metal layer 310 of the first circuit pattern part 300a may be greater than the thickness of the first metal layer 310 of the second-second circuit pattern part 300b2. In addition, the thickness of the first metal layer 310 of the second-second circuit pattern part 300b2 may be greater than the thickness of the first metal layer 310 of the second-first circuit pattern part 300b1.

In addition, the difference between the thickness of the first metal layer 310 of the first circuit pattern part 300a and the thickness of the first metal layer 310 of the second-first circuit pattern part 300b1 may be greater than or equal to the difference between the thickness of the first metal layer 310 of the second-second circuit pattern part 300b2 and the thickness of the second-first circuit pattern part 300b1.

The second-second circuit pattern part 300b2 may be disposed in the first region 1A. Specifically, the second-second circuit pattern part 300b2 may be disposed only in the first region 1A.

That is, the second-first circuit pattern part 300b1 and the second-second circuit pattern part 300b2 may be disposed in the first region 1A in which the identification pattern IP is formed.

Accordingly, an identification pattern IP may be formed in the first region 1A by the second-first circuit pattern part 300b1 and the second-second circuit pattern part 300b2.

In detail, an identification pattern IP may be formed in the first region 1A by the second-first circuit pattern part 300b1 and the second-second circuit pattern part 300b2 of the first circuit pattern 300 having different thicknesses.

That is, a pattern including texts, symbols, or numbers may be formed on the smart IC substrate 1200 by the second-first circuit pattern part 300b1 and the second-second circuit pattern part 300b2. That is, an identification pattern IP including embossed texts, symbols, or numbers may be formed on the smart IC substrate 1200.

The second-first circuit pattern part 300b1 and the second-second circuit pattern part 300b2 may be recognized as different colors. Specifically, the first circuit pattern part 300a and the second-first circuit pattern part 300b1 may have different thicknesses due to the difference in thickness of the first metal layer 310. Accordingly, a difference in contrast occurs between the first circuit pattern part 300a and the second-first circuit pattern part 300b1 due to a difference in thickness. Accordingly, the user can recognize the first circuit pattern part 300a and the second-first circuit pattern part 300b1 as different colors from the outside due to the difference in contrast.

Therefore, since the second-first circuit pattern part 300b1 and the second-second circuit pattern part 300b2 are distinguished by a difference in thickness or color, the user can easily identify the identification pattern of the IC card from the outside.

In addition, since the first circuit pattern part 300a, the second-first circuit pattern part 300b1, and the second-second circuit pattern part 300b2 have different thicknesses, the user can recognize at least three or more colors from the outside. Accordingly, the degree of freedom in external design of the IC card can be improved.

In addition, the second-first circuit pattern part 300b1 may be disposed in the first region 1A regardless of the positions of the via holes V1, V2, V3, V4, V5, and V6. Accordingly, the identification pattern IP formed by the second-first circuit pattern part 300b1 and the second-second circuit pattern part 300b2 may also be disposed regardless of the positions of the via holes V1, V2, V3, V4, V5, and V6.

Therefore, when the identification pattern is formed on the IC card, identification patterns may be formed at various positions regardless of the position of the via hole formed in the substrate. Accordingly, the degree of design freedom of the identification pattern may be improved.

In addition, the thickness of both the second-first circuit pattern part 300b1 and the second-second circuit pattern part 300b2 disposed in the first region 1A may be smaller than the thickness of the first circuit pattern part 300a disposed in the second region 2A.

Accordingly, a difference in contrast due to a difference in thickness may occur in the first region 1A and the second region 2A. That is, a difference in contrast may occur due to a difference in thickness between the second-second circuit pattern part 300b2 and the thickness of the first circuit pattern part 300a having the shape of an identification pattern IP in the first region 1A. Accordingly, the user can easily recognize the identification pattern IP disposed in the first region 1A from the outside. In addition, more various designs of identification patterns may be formed by using the difference in contrast.

The third circuit pattern part 300c may be a region in which the first circuit pattern 300 is etched. Specifically, the third circuit pattern part 300c may be a region in which the first circuit pattern 300 is completely or almost etched. That is, the first circuit pattern 300 may not remain in the third circuit pattern part 300c or may remain in a small amount. That is, the thickness of the first circuit pattern 300 disposed on the third circuit pattern part 300c may be zero or close to zero.

Here, the meaning that the third circuit pattern part 300c remains means that the first circuit pattern 300 is not connected to adjacent circuit patterns on the first surface 1S of the substrate 100 after etching. Additionally, it means that it remains in an amount such that a plating layer is not formed by the plating process.

The third circuit pattern part 300c may correspond to the space region SA. That is, the third circuit pattern part 300c may be the space region SA. That is, the first circuit pattern 300 may be divided into a plurality of circuit patterns by the third circuit pattern part 300c.

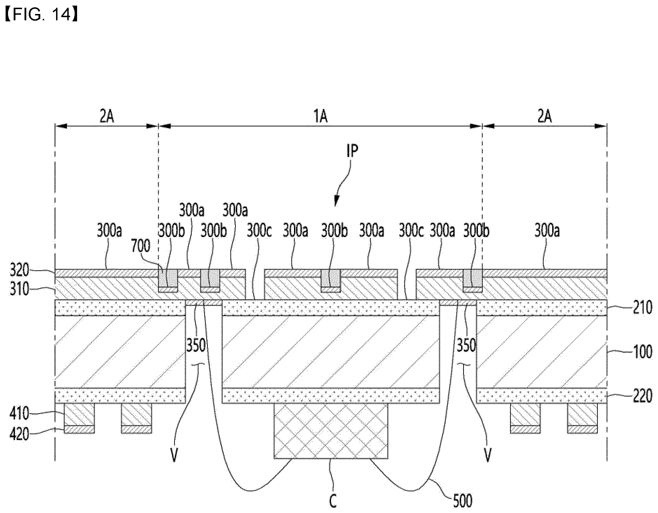

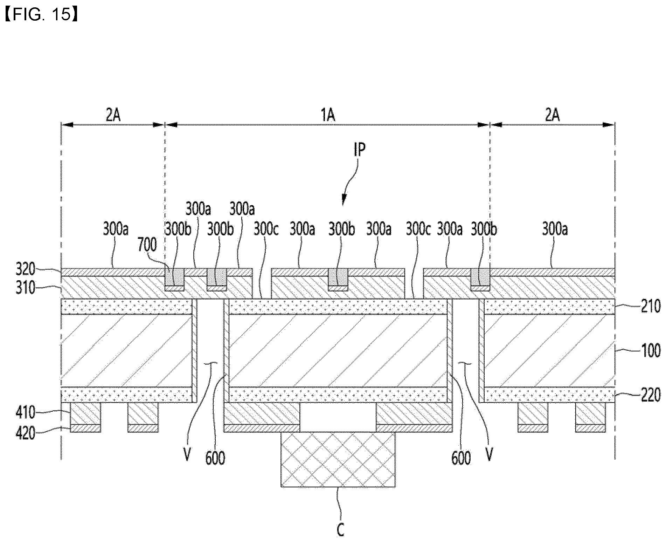

Hereinafter, the identification pattern of the smart IC substrate according to a fourth embodiment will be described with reference to FIGS. 2, 6, 7, 14, and 15.

In the description of the identification pattern of the smart IC substrate according to the fourth embodiment, a description similar to the identification pattern of the smart IC substrate according to the first embodiment described above is omitted.

Referring to FIGS. 2, 6, 7, 14, and 15, the smart IC substrate according to the fourth embodiment may further include a reinforcing part 700.

The reinforcing part 700 may be disposed on the second circuit pattern part 300b. Specifically, the reinforcing part 700 may be disposed to extend along the shape of the identification pattern IP.

The reinforcing part 700 may include a resin material or a metal material. The reinforcing part 700 may be disposed on the second metal layer 320 of the second circuit pattern part 300b.

As described above, the second metal layer 320 serves as a protective layer for preventing corrosion of the first metal layer 310. Since the first metal layer 320 is partially removed, the second circuit pattern part 300b may have a step difference from the first circuit pattern part 300a. As a result, the first metal layer 310 may be exposed from the side of the first circuit pattern part 300a. Accordingly, the first circuit pattern part 300a may be corroded by external moisture or oxygen.

Accordingly, the reinforcing part 700 may be disposed on the second metal layer 310 of the second circuit pattern part 300b. The reinforcing part 700 may be disposed in contact with a side surface of the first circuit pattern part 300a. Accordingly, the first circuit pattern part 300a may be prevented from being corroded by the reinforcing part 700.

The reinforcing part 700 may have a color. For example, the reinforcing part 700 may include a resin material having a color. Alternatively, the reinforcing part 700 may include a metal material whose color coordinates are different from those of the first metal layer 310 and the second metal layer 320.

Therefore, the second circuit pattern part 300b having the shape of the identification pattern IP may have various colors. Accordingly, the degree of design freedom may be improved by implementing the identification pattern IP in various colors. In addition, the user can easily identify the identification pattern IP from the outside.

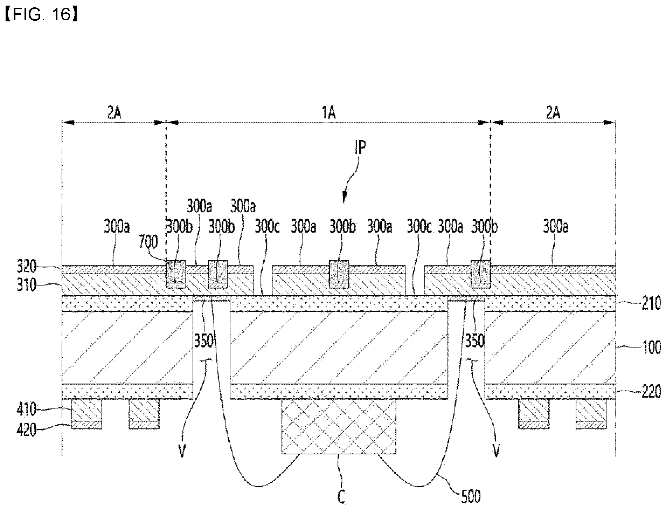

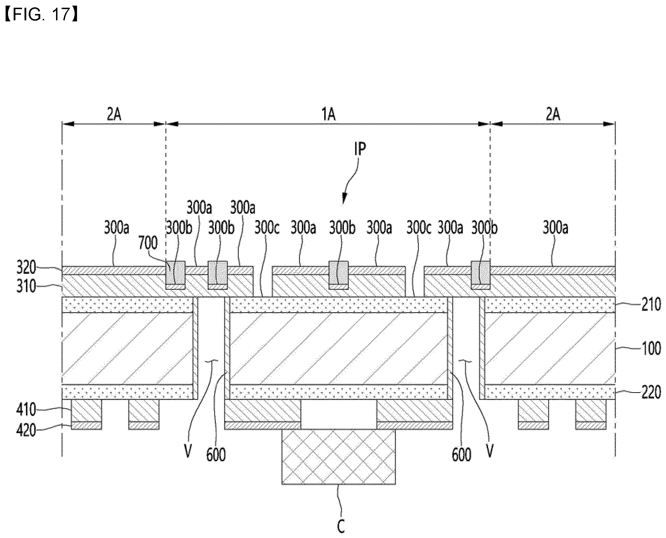

Hereinafter, the identification pattern of the smart IC substrate according to the fifth embodiment will be described with reference to FIGS. 2, 6, 7, 16, and 17.

In the description of the identification pattern of the smart IC substrate according to the fifth embodiment, a description similar to the identification pattern of the smart IC substrate according to the first and fourth embodiments described above is omitted.

Referring to FIGS. 2, 6, 7, 16, and 17, the smart IC substrate according to the fifth embodiment may further include a reinforcing part 700.

The reinforcing part 700 may be disposed on the second circuit pattern part 300b. Specifically, the reinforcing part 700 may be disposed to extend along the shape of the identification pattern IP.

The reinforcing part 700 may include a resin material or a metal material. The reinforcing part 700 may be disposed on the second metal layer 320 of the second circuit pattern part 300b.

As described above, the second metal layer 320 serves as a protective layer for preventing corrosion of the first metal layer 310. Since the first metal layer 320 is partially removed, the second circuit pattern part 300b may have a step difference from the first circuit pattern part 300a. Accordingly, the first metal layer 310 may be exposed on the side surface of the first circuit pattern part 300a. Accordingly, the first circuit pattern part 300a may be corroded by external moisture or oxygen.

Accordingly, the reinforcing part 700 may be disposed on the second metal layer 310 of the second circuit pattern part 300b. The reinforcing part 700 may be disposed in contact with a side surface of the first circuit pattern part 300a. Accordingly, the first circuit pattern part 300a may be prevented from being corroded by the reinforcing part 700.

The reinforcing part 700 may have a color. For example, the reinforcing part 700 may include a resin material having a color. Alternatively, the reinforcing part 700 may include a metal material whose color coordinates are different from those of the first metal layer 310 and the second metal layer 320.

Therefore, the second circuit pattern part 300b having the shape of the identification pattern IP may have various colors. Accordingly, it is possible to improve the degree of design freedom by implementing the identification pattern IP in various colors. Accordingly, the user can easily identify the identification pattern IP from the outside.

Also, the reinforcing part 700 may be disposed to protrude. Specifically, the reinforcing part 700 may be disposed to protrude from an upper surface of the circuit pattern. Specifically, the reinforcing part 700 may be disposed to protrude from the upper surface of the first circuit pattern 300. More specifically, the reinforcing part 700 may be disposed to protrude from the upper surface of the second metal layer 320.

That is, the upper surface of the reinforcing part 700 may be disposed to protrude from the upper surface of the second metal layer 320. Accordingly, the reinforcing part 700 extending along the shape of the identification pattern IP may be disposed to protrude from the upper surface of the smart IC substrate 1200.

Therefore, the user can easily identify the identification pattern IP from the outside due to the difference in contrast according to the height difference between the reinforcing part 700 and the smart IC substrate 1200. In addition, by the reinforcing part 700 extending according to the shape of the identification pattern IP, the user may recognize the identification pattern IP from the outside by not only sight but also touch. Therefore, the function of the identification pattern IP may be diversified.

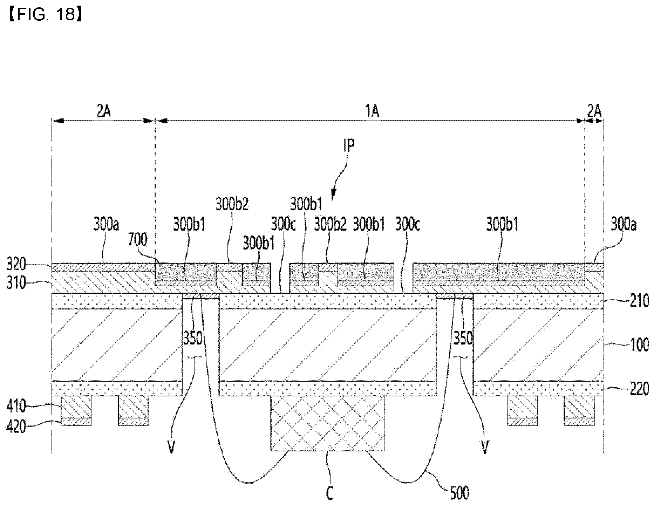

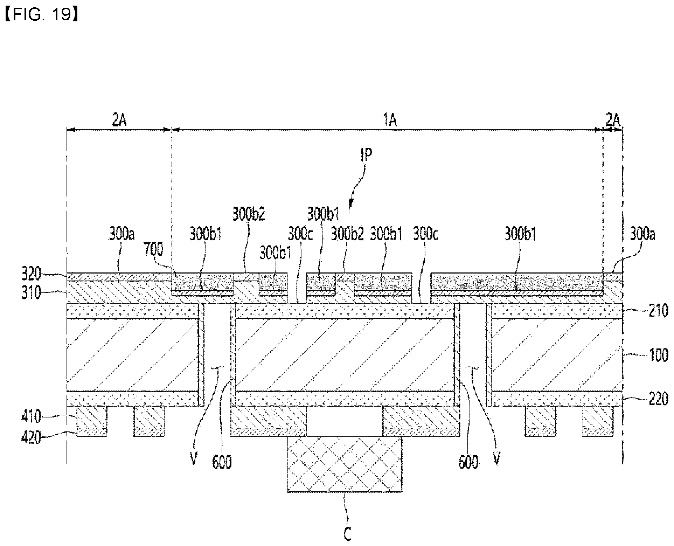

Hereinafter, the identification pattern of the smart IC substrate according to the sixth embodiment will be described with reference to FIGS. 3, 6, 7, 18, and 19.

In the description of the identification pattern of the smart IC substrate according to the sixth embodiment, a description similar to the identification pattern of the smart IC substrate according to the second embodiment described above is omitted.

Referring to FIGS. 3, 6, 7, 18, and 19, the smart IC substrate according to the sixth embodiment may further include a reinforcing part 700.

The reinforcing part 700 may be disposed on the second circuit pattern part 300b. Specifically, the reinforcing part 700 may be disposed to extend along the shape of the identification pattern IP.

The reinforcing part 700 may include a resin material or a metal material. The reinforcing part 700 may be disposed on the second metal layer 320 of the second-first circuit pattern part 300b1.

As described above, the second metal layer 320 serves as a protective layer for preventing corrosion of the first metal layer 310. Since the first metal layer 320 is partially removed, the second-first circuit pattern part 300b1 may have a step difference from the first circuit pattern part 300a. Accordingly, the first metal layer 310 may be exposed on the side surface of the first circuit pattern part 300a. Accordingly, the first circuit pattern part 300a may be corroded by external moisture or oxygen.

Accordingly, the reinforcing part 700 may be disposed on the second metal layer 310 of the second-first circuit pattern part 300b1. The reinforcing part 700 may be disposed in contact with a side surface of the first circuit pattern part 300a. Accordingly, the first circuit pattern part 300a may be prevented from being corroded by the reinforcing part 700.

The reinforcing part 700 may have a color. For example, the reinforcing part 700 may include a resin material having a color. Alternatively, the reinforcing part 700 may include a metal material whose color coordinates are different from those of the first metal layer 310 and the second metal layer 320.

Accordingly, the second-first circuit pattern part 300b1 having the shape of the identification pattern IP may have various colors. Accordingly, the degree of design freedom may be improved by implementing the identification pattern IP in various colors. Accordingly, the user can easily identify the identification pattern IP from the outside.

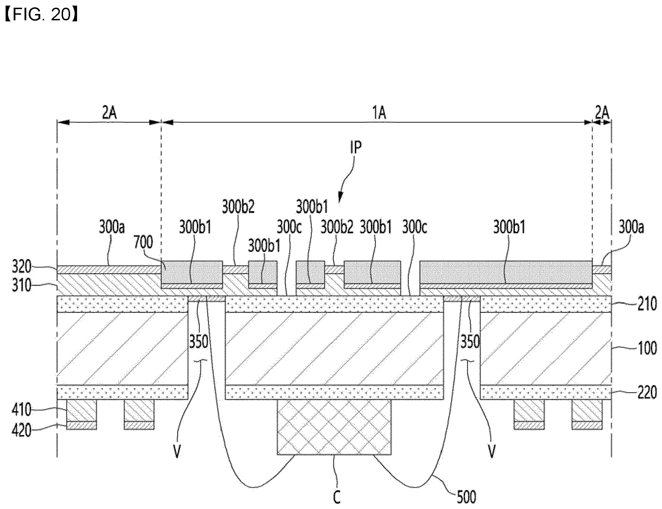

Hereinafter, the identification pattern of the smart IC substrate according to the seventh embodiment will be described with reference to FIGS. 3, 6, 7, 20, and 21.

In the description of the identification pattern of the smart IC substrate according to the seventh embodiment, a description similar to the identification pattern of the smart IC substrate according to the second and sixth embodiments described above is omitted.

Referring to FIGS. 3, 6, 7, 20, and 21, the smart IC substrate according to the seventh embodiment may further include a reinforcing part 700.

The reinforcing part 700 may be disposed on the second circuit pattern part 300b. Specifically, the reinforcing part 700 may be disposed to extend along the shape of the identification pattern IP.

The reinforcing part 700 may include a resin material or a metal material. The reinforcing part 700 may be disposed on the first metal layer 310 of the second-first circuit pattern part 300b1.

As described above, the second metal layer 320 serves as a protective layer for preventing corrosion of the first metal layer 310. Since the first metal layer 320 is partially removed, the second-first circuit pattern part 300b1 may have a step difference from the first circuit pattern part 300a. Accordingly, the first metal layer 310 may be exposed on a side surface of the first circuit pattern part 300a. Accordingly, the first circuit pattern part 300a may be corroded by external moisture or oxygen.

Accordingly, the reinforcing part 700 may be disposed on the second metal layer 310 of the second-first circuit pattern part 300b1. Also, the reinforcing part 700 may be disposed in contact with a side surface of the first circuit pattern part 300a. Accordingly, the first circuit pattern part 300a may be prevented from being corroded by the reinforcing part 700.

The reinforcing part 700 may have a color. For example, the reinforcing part 700 may include a resin material having a color. Alternatively, the reinforcing part 700 may include a metal material whose color coordinates are different from those of the first metal layer 310 and the second metal layer 320.

Accordingly, the second-first circuit pattern part 300b1 having the shape of the identification pattern IP may have various colors. Accordingly, the degree of design freedom may be improved by implementing the identification pattern IP in various colors, thereby allowing the user to easily identify the identification pattern IP from the outside.

Also, the reinforcing part 700 may be disposed to protrude. Specifically, the reinforcing part 700 may be disposed to protrude from the upper surface of the circuit pattern. Specifically, the reinforcing part 700 may be disposed to protrude from the upper surface of the first circuit pattern 300. More specifically, the reinforcing part 700 may be disposed to protrude from the upper surface of the second metal layer 320.

That is, the upper surface of the reinforcing part 700 may be disposed to protrude from the upper surface of the second metal layer 320. Accordingly, the reinforcing part 700 extending along the shape of the identification pattern IP may be disposed to protrude from the upper surface of the smart IC substrate 1200.

Therefore, the user can easily identify the identification pattern IP by a difference in contrast according to the height difference between the reinforcing part 700 and the smart IC substrate 1200 from the outside. In addition, by the reinforcing part 700 extending according to the shape of the identification pattern IP, the user may recognize the identification pattern IP from the outside by not only sight but also touch. Therefore, the function of the identification pattern IP may be diversified.

Hereinafter, the identification pattern of the smart IC substrate according to the eighth embodiment will be described with reference to FIGS. 2, 6, 7, 22, and 23.

In the description of the identification pattern of the smart IC substrate according to the eighth embodiment, a description similar to the identification pattern of the smart IC substrate according to the first embodiment described above is omitted.

Referring to FIGS. 2, 6, 7, 22, and 23, in the smart IC substrate according to the eighth embodiment, the second circuit pattern part 300b may include only the first metal layer 310.

The first circuit pattern 300 may be defined as a first circuit pattern part 300a, a second circuit pattern part 300b, and a third circuit pattern part 300c.

The second circuit pattern part 300b may include only the first metal layer 310. That is, unlike the first circuit pattern part 300a, the second circuit pattern part 300b may not include the second metal layer 320.

That is, the smart IC substrate according to the first embodiment proceeds with a process of forming a first metal layer, a process of partially etching the first metal layer, and a process of forming a second metal layer. Accordingly, the first circuit pattern 300 of the second circuit pattern part 300b includes both the first metal layer and the second metal layer. On the other hand, the smart IC substrate according to the eighth embodiment forms both the first metal layer and the second metal layer, and then partially etching the second metal layer and the first metal layer. Accordingly, the first circuit pattern 300 of the second circuit pattern part 300b may include only the first metal layer.

The second circuit pattern part 300b may be disposed in the first region 1A. Specifically, the second circuit pattern part 300b may be disposed only in the first region 1A.

Also, thicknesses of the first metal layer 310 of the first circuit pattern part 300a and the first metal layer 310 of the second circuit pattern part 300b may be different. Specifically, the first metal layer 310 of the first circuit pattern part 300a may be greater than the thickness of the first metal layer 310 of the second circuit pattern part 300b.

Accordingly, the first circuit pattern part 300a and the second circuit pattern part 300b may have different thicknesses depending on the difference in thickness of the first metal layer 310 and the presence or absence of the second metal layer 320.

The first circuit pattern part 300a and the second circuit pattern part 300b may have different colors. Specifically, the first circuit pattern part 300a may have a color according to the material of the second metal layer 320. Also, the second circuit pattern part 300b may have a color according to the material of the first metal layer 310. That is, the first surface 1S on which the first circuit pattern 300 is disposed may have at least two or more colors.

Accordingly, the first surface 1 S exposed to the outside of the IC card may have various colors. Accordingly, the degree of freedom of design may be improved. Also, the first circuit pattern part 300a and the second circuit pattern part 300 may be distinguished by a difference in thickness or a difference in color. Accordingly, the user can easily identify the identification pattern of the IC card from the outside.

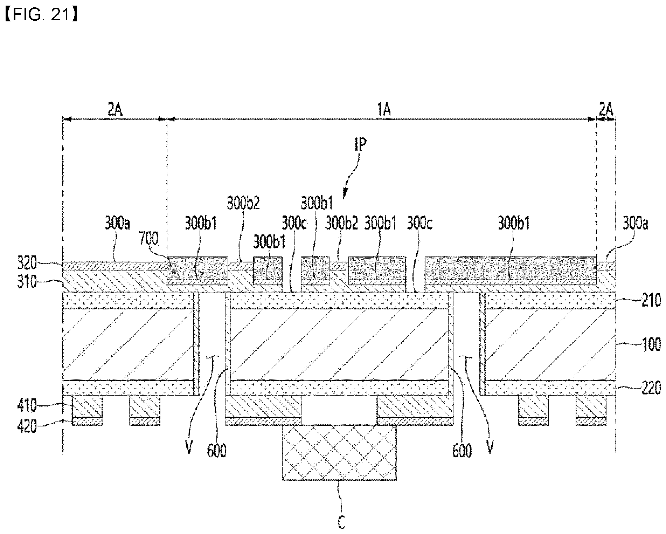

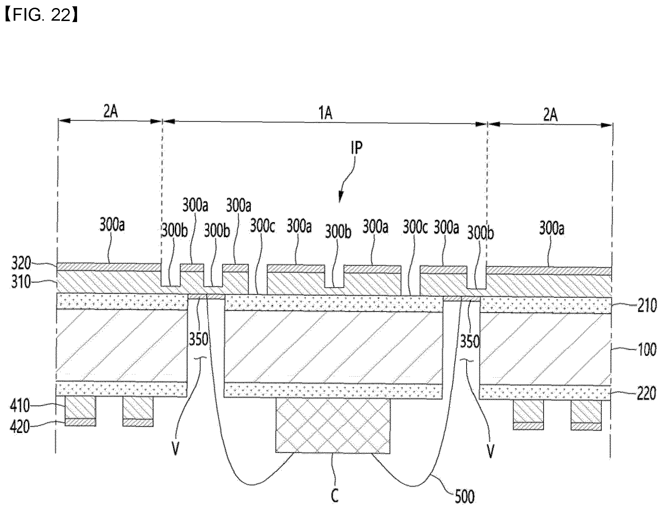

Although it is not illustrated in Figs. 21 and 22, the reinforcing part described above can be disposed on the second circuit pattern part 300b.

The second metal layer 320 is removed from the second circuit pattern part 300b. Accordingly, the second circuit pattern part 300b through which the first metal layer 310 is exposed may be more vulnerable to corrosion than other circuit pattern parts.

Accordingly, a reinforcing part may be disposed on the first metal layer 310 of the second circuit pattern part 300b. Accordingly, the second circuit pattern part 300b may be prevented from being corroded.

In addition, by giving color to the reinforcing part, the second circuit pattern part 300b having the shape of the identification pattern IP may be implemented in various colors. Accordingly, the identification pattern IP may be implemented in various colors to improve design freedom. In addition, the user can easily identify the identification pattern IP from the outside.

In addition, the reinforcing part may be disposed lower than the upper surface of the circuit pattern. Alternatively, the reinforcing part may be disposed on the same plane as the circuit pattern. Alternatively, the reinforcing part may be disposed to protrude from the circuit pattern. For example, the reinforcing part may be disposed to protrude from the upper surface of the first circuit pattern 300. In more detail, the reinforcing part may be disposed to protrude from the upper surface of the second metal layer 320.

Therefore, the user can easily identify the identification pattern IP from the outside due to the difference in contrast according to the height difference between the reinforcing part and the smart IC substrate 1200. In addition, by the reinforcing part 700 extending according to the shape of the identification pattern IP, the user may recognize the identification pattern IP from the outside by not only sight but also touch. Therefore, the function of the identification pattern IP may be diversified.

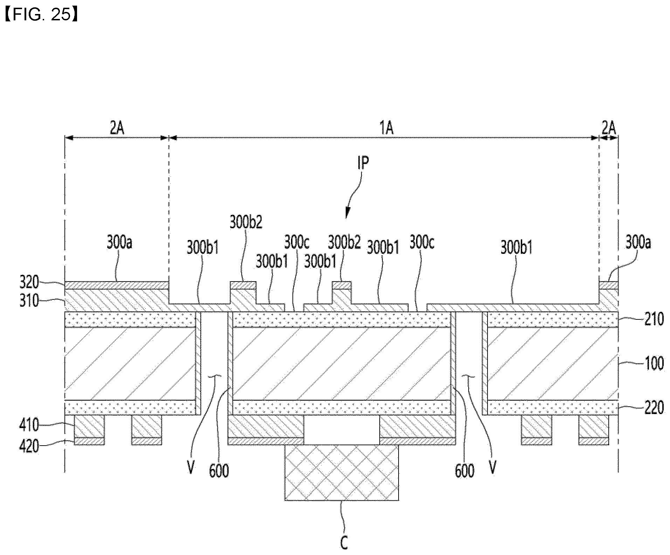

Hereinafter, the identification pattern of the smart IC substrate according to the ninth embodiment will be described with reference to FIGS. 3, 6, 7, 24, and 25.

In the description of the identification pattern of the smart IC substrate according to the ninth embodiment, a description similar to the identification pattern of the smart IC substrate according to the second embodiment described above is omitted.

Referring to FIGS. 3, 6, 7, 24, and 25, in the smart IC substrate according to the ninth embodiment, the second-first circuit pattern part 300b1 may include only the first metal layer 310.

That is, the smart IC substrate according to the first embodiment proceeds with a process of forming a first metal layer, a process of partially etching the first metal layer, and a process of forming a second metal layer. Accordingly, the first circuit pattern 300 of the second circuit pattern part 300b includes both the first metal layer and the second metal layer. On the other hand, the smart IC substrate according to the ninth embodiment forms both the first metal layer and the second metal layer, and then etches the second metal layer and a part of the first metal layer. Accordingly, the first circuit pattern 300 of the second circuit pattern part 300b may include only the first metal layer.

In the first circuit pattern 300, a first circuit pattern part 300a, a second-first circuit pattern part 300b1, a second-second circuit pattern part 300b2, and a third circuit pattern part 300c may be defined according to the thickness of the first circuit pattern 300.

The second-first circuit pattern part 300b1 may include only the first metal layer 310. That is, unlike the first circuit pattern part 300a, the second-first circuit pattern part 300b1 may not include the second metal layer 320.

The second-first circuit pattern part 300b1 may be disposed in the first region 1A. Specifically, the second-first circuit pattern part 300b1 may be disposed only in the first region 1A.

Also, thicknesses of the first metal layer 310 of the first circuit pattern part 300a and the first metal layer 310 of the second-first circuit pattern part 300b1 may be different from each other. Specifically, the first metal layer 310 of the first circuit pattern part 300a may be greater than the thickness of the first metal layer 310 of the second-first circuit pattern part 300b1.

Accordingly, the first circuit pattern part 300a and the second-first circuit pattern part 300b1 may have different thicknesses depending on the difference in thickness of the first metal layer 310 and the presence or absence of the second metal layer 320.

The first circuit pattern part 300a and the second-first circuit pattern part 300b1 may have different colors. In detail, the first circuit pattern part 300a may have a color according to the material of the second metal layer 320. Also, the second-first circuit pattern part 300b1 may have a color according to the material of the first metal layer 320. That is, the first surface 1S on which the first circuit pattern 300 is disposed may have at least two or more colors.

Accordingly, the degree of design freedom of the first surface 1S exposed to the outside of the IC card may be improved.

Also, the second-first circuit pattern part 300b1 and the second-second circuit pattern part 300b2 may have different colors. Specifically, the second-first circuit pattern part 300b1 may have a color according to the material of the first metal layer 310. Also, the second-second circuit pattern part 300b2 may have a color according to the material of the second metal layer 320. That is, the first region 1A on which the identification pattern IP is disposed may have at least two or more colors.

Accordingly, the second-first circuit pattern part 300b1 and the second-second circuit pattern part 300b2 are divided by a difference in thickness or color, so that the user can easily identify the identification pattern of the IC card from the outside.

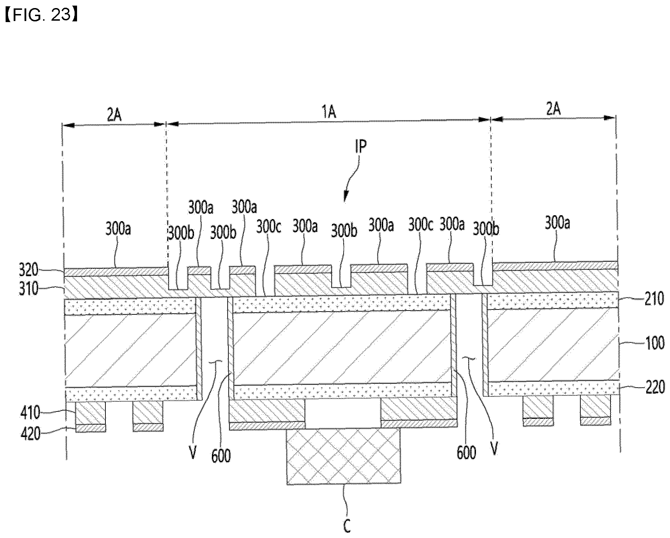

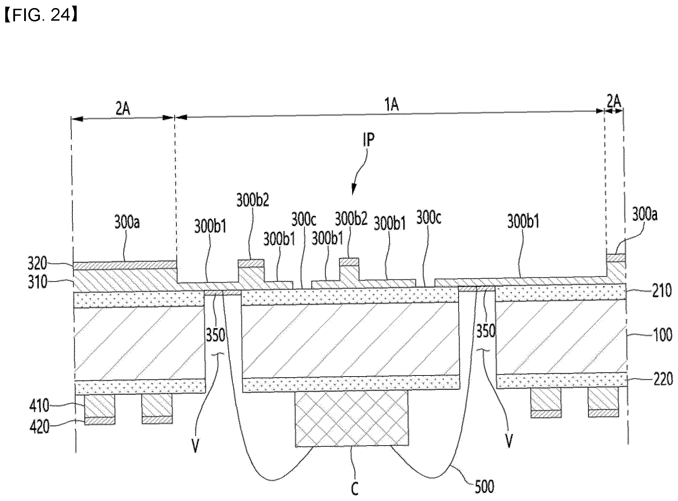

Although it is not shown in FIGS. 23 and 24, the reinforcing part described above may be disposed on the second-first circuit pattern part 300b1.

The second metal layer 320 is removed from the second-first circuit pattern part 300b1. Accordingly, the second-first circuit pattern part 300b1 through which the first metal layer 310 is exposed may be more vulnerable to corrosion than other circuit pattern parts.

Accordingly, a reinforcing part may be disposed on the first metal layer 310 of the second-first circuit pattern part 300b1. Accordingly, the second circuit pattern part 300b may be prevented from being corroded.

In addition, the second-first circuit pattern part 300b1 having the shape of the identification pattern IP may be implemented in various colors by giving a color to the reinforcing part. Accordingly, it is possible to improve the degree of design freedom by implementing the identification pattern IP in various colors. Accordingly, the user can easily identify the identification pattern IP from the outside.

In addition, the reinforcing part may be disposed lower than the upper surface of the circuit pattern. Alternatively, the reinforcing part may be disposed in the same plane as the upper surface of the circuit pattern. Alternatively, the reinforcing part may be disposed to protrude from the upper surface of the circuit pattern. For example, the reinforcing part may be disposed to protrude from the upper surface of the first circuit pattern 300. In more detail, the reinforcing part may be disposed to protrude from the upper surface of the second metal layer 320.

Therefore, the user may easily identify the identification pattern IP from the outside by a difference in contrast according to the height difference between the reinforcing part and the smart IC substrate 1200. In addition, by the reinforcing part 700 extending according to the shape of the identification pattern IP, the user may recognize the identification pattern IP from the outside by not only sight but also touch. Therefore, the function of the identification pattern IP may be diversified.

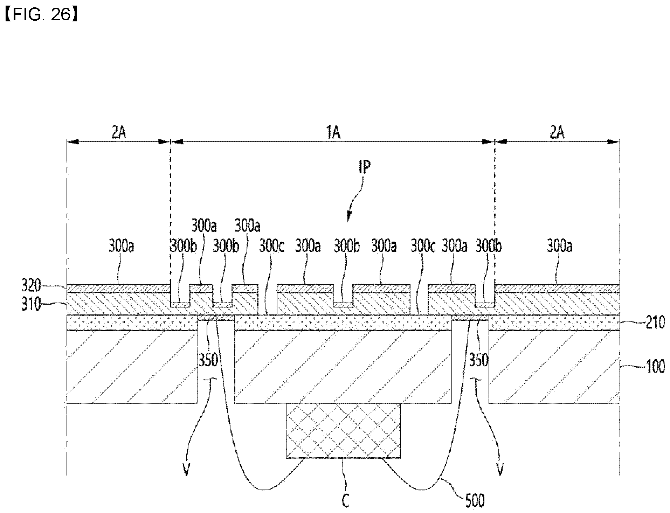

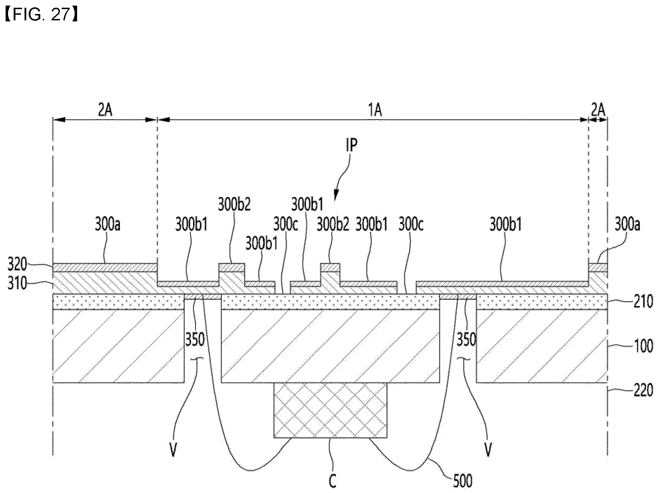

Meanwhile, a dual-type smart IC substrate, a smart IC module, and an IC card in which circuit patterns are disposed on both the first surface 1S and the second surface 2S of the substrate 100 have been described above, but the embodiment is not limited thereto. Specifically, referring to FIGS. 26 and 27, the embodiment may be applied to a single-type smart IC substrate, a smart IC module, and an IC card.

That is, referring to FIGS. 26 and 27, a circuit pattern of the smart IC substrate, the smart IC module, and the IC card may be disposed only on the first surface 1S in the embodiment. Also, only a chip C may be disposed on the second surface 2S. Also, the circuit pattern disposed on the first surface 1S may implement an identification pattern by partial etching as described above.

That is, the smart IC substrate, the smart IC module, and the IC card according to an embodiment may be applied to both the single type and the dual type.

The smart IC substrate, smart IC module, and IC card according to the embodiment include an identification pattern.

In detail, the circuit pattern is etched to form an identification pattern having an engraved or embossed shape.

Accordingly, the user can easily identify the information of the IC card from the outside through the identification pattern.

Additionally, the identification pattern may be formed by partially etching the circuit pattern. Accordingly, the identification pattern can be formed at various positions regardless of a position of the via hole.

Additionally, the identification pattern may be recognized in a different color from other circuit patterns. Accordingly, the user can easily identify the identification pattern from the outside.

Additionally, the identification pattern may have a different color from other circuit patterns. Accordingly, the user can easily identify the identification pattern from the outside.

Additionally, a reinforcing part made of resin or metal may be disposed on the identification pattern. Accordingly, corrosion of the circuit pattern can be prevented. Additionally, the degree of freedom in exterior design can be improved by applying various colors to the reinforcing part.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The above description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A smart IC substrate comprising:
a substrate including a first surface and a second surface opposite to the first surface;
a first circuit pattern disposed on the first surface; and
a space region between the first circuit pattern,
wherein the substrate includes a plurality of via holes passing through the first surface and the second surface,
wherein the substrate has a first region and a second region other than the first region,
wherein the first circuit pattern includes a first circuit pattern part and a second circuit pattern part having different thicknesses,
wherein a thickness of the first circuit pattern part is greater than a thickness of the second circuit pattern part,
wherein the first circuit pattern part is disposed in the first region and the second region,
wherein the second circuit pattern part is disposed only in the first region, and
wherein the second circuit pattern part is disposed in at least one of a position that overlaps the via hole and a position that does not overlap the via hole in a thickness direction of the substrate.

2. The smart IC substrate of claim 1, wherein the first circuit pattern includes a first metal layer and a second metal layer on the first metal layer, and
wherein a thickness of the first metal layer of the first circuit pattern part is greater than a thickness of the first metal layer of the second circuit pattern part.

3. The smart IC substrate of claim 1, wherein the thickness of the second circuit pattern part is 10% to 50% of the thickness of the first circuit pattern part.

4. The smart IC substrate of claim 1, wherein a difference between the thicknesses between the first circuit pattern part and the second circuit pattern part 300b is 3.5 µm to 18 µm.

5. The smart IC substrate of claim 1, wherein the second circuit pattern part includes an identification pattern representing a logo, text, or symbol.

6. A smart IC substrate comprising:
a substrate including a first surface and a second surface opposite to the first surface;
a first circuit pattern disposed on the first surface; and
a space region between the first circuit pattern,
wherein the substrate includes a plurality of via holes passing through the first surface and the second surface,
wherein the substrate has a first region and a second region other than the first region,
wherein the first circuit pattern includes a first circuit pattern part, a second-first circuit pattern part, and a second-second circuit pattern part having different thicknesses,
wherein a thickness of the first circuit pattern part and a thickness of the second-second circuit pattern part are greater than a thickness of the second-first circuit pattern part,
wherein the first circuit pattern part is disposed in the second region,
wherein the second-first circuit pattern part and the second-second circuit pattern part are disposed only in the first region, and
wherein the second-first circuit pattern part is disposed in at least one of a position that overlaps the via hole and a position that does not overlap the via hole in a thickness direction of the substrate.

7. The smart IC substrate of claim 6, wherein the first circuit pattern includes a first metal layer and a second metal layer on the first metal layer, and
wherein a thickness of the first metal layer of the first circuit pattern part is greater than a thickness of the first metal layer of the second-first circuit pattern part.

8. The smart IC substrate of claim 6, wherein a thickness of the second-first circuit pattern part is 10% to 50% of a thickness of the first circuit pattern part.

9. The smart IC substrate of claim 6, wherein a difference between thicknesses of the first circuit pattern part and the second-first circuit pattern part is 3.5 µm to 18 µm.

10. The smart IC substrate of claim 6, wherein further comprising:
a reinforcing part disposed on the second-first circuit pattern part.
